# EUROPEAN PATENT APPLICATION

(11) **EP 4 814 967 A1**
(43) Date of publication of application: **30.09.2026**
(21) Application number: 26157218.4
(22) Date of filing: 09.02.2026
(51) Int. Cl.: G11C 16/26, G11C 29/02, G11C 7/06, G11C 7/10, G11C 11/56, G11C 16/04

(54) **SEMICONDUCTOR STORAGE DEVICE**

(30) Priority: 24.03.2025 JP 2025048728; 22.08.2025 US 202519308046
(71) Applicant: Kioxia Corporation, Tokyo (JP)
(72) Inventor: FUJIMURA, Susumu, Minato-ku, Tokyo (JP); KODAMA, Takuyo, Minato-ku, Tokyo (JP); HANDA, Takaya, Minato-ku, Tokyo (JP)
(74) Representative: Hoffmann Eitle

(57) **Abstract**

A semiconductor storage device includes a control circuit configured to perform a read operation including a first process and a second process. The control circuit counts, in the first process, a first cell count based on first read data held by a latch circuit and a second voltage held by a sense node. The control circuit counts a second cell count based on the first read data restored to the latch circuit and a third voltage held by the sense node. The control circuit acquires a third cell count by computing a difference between the first cell count and the second cell count, and determines a selected sense parameter. The control circuit reads data from a memory cell transistor using the selected sense parameter in the second process.

## Description

### CROSS-REFERENCE TO RELATED APPLICATION

This application is based upon and claims the benefit of priority from the prior Japanese Patent Applications No. 2025-48728, filed on Mar. 24, 2025.

### FIELD

An embodiment described herein generally relates to a semiconductor storage device.

### BACKGROUND

As a semiconductor storage device, a NAND flash memory is known.

### BRIEF DESCRIPTION OF THE DRAWINGS

FIG. 1 is a block diagram showing a schematic configuration of a memory system according to a first embodiment;
FIG. 2 is a block diagram showing a schematic configuration of a semiconductor storage device according to the first embodiment;
FIG. 3 is a circuit diagram showing a configuration of a semiconductor storage device according to the first embodiment;
FIG. 4 is a sectional view showing a sectional structure of the semiconductor storage device according to the first embodiment;
FIG. 5 is a block diagram showing a configuration of a sense amplifier unit according to the first embodiment;
FIG. 6 is a circuit diagram showing a configuration of a latch circuit according to the first embodiment;
FIG. 7A is a diagram showing an example of threshold voltage distribution of a QLC memory cell transistor according to the first embodiment;
FIG. 7B is a diagram showing an example of voltage variation in each piece of wiring at the time of read operation (normal read operation) for data of a certain page in the threshold voltage distribution according to the first embodiment;
FIG. 8 is a diagram showing an example of a variation aspect of the threshold voltage distribution of the memory cell transistor according to the first embodiment;
FIG. 9 is a diagram showing an example of the threshold voltage distribution of the memory cell transistor according to the first embodiment;
FIG. 10 is a diagram showing an example of the threshold voltage distribution of the memory cell transistor according to the first embodiment;
FIG. **11** is a diagram showing an example of the threshold voltage distribution of the memory cell transistor according to the first embodiment;
FIG. 12 is a flowchart showing a procedure of a process performed by a sequencer according to the first embodiment;
FIG. 13 is a diagram showing an example of a method for setting an optimum read voltage according to the first embodiment;
FIG. 14A is a flowchart showing a procedure of a process performed by the sequencer according to the first embodiment;
FIG. 14B is a diagram showing an example of voltage variation in each piece of wiring at the time of adjustment read operation according to the first embodiment;
FIG. 15 is a diagram showing transition of a voltage level of a node SEN and transition of data held by a node LAT_S of a latch circuit SDL according to the first embodiment;
FIG. 16 is a circuit diagram showing an operation example of a sense amplifier unit according to the first embodiment;
FIG. 17 is a circuit diagram showing an operation example of the sense amplifier unit according to the first embodiment;
FIG. 18 is a timing chart showing transition of each signal of a sense amplification part, transition of each signal of the latch circuit SDL, transition of a voltage level of a bus LBUS, transition of a voltage level at the node SEN, and transition of a voltage level at the node LAT_S of the latch circuit SDL in the semiconductor storage device according to the first embodiment;
FIG. 19 is a circuit diagram showing an operation example of the sense amplifier unit according to the first embodiment;
FIG. 20 is a circuit diagram showing an operation example of the sense amplifier unit according to the first embodiment;
FIG. 21 is a circuit diagram showing an operation example of the sense amplifier unit according to the first embodiment;
FIG. 22 is a circuit diagram showing an operation example of the sense amplifier unit according to the first embodiment;
FIG. 23 is a circuit diagram showing an operation example of the sense amplifier unit according to the first embodiment;
FIG. 24 is a circuit diagram showing an operation example of the sense amplifier unit according to the first embodiment;
FIG. 25 is a timing chart showing transition of each signal of the sense amplification part, transition of each signal of the latch circuit SDL, transition of a voltage level of the bus LBUS, transition of a voltage level at the node SEN, and transition of a voltage level at the node LAT_S of the latch circuit SDL in the semiconductor storage device according to the first embodiment;
FIG. 26 is a circuit diagram showing an operation example of the sense amplifier unit according to the first embodiment;
FIG. 27 is a circuit diagram showing an operation example of the sense amplifier unit according to the first embodiment;
FIG. 28 is a circuit diagram showing an operation example of the sense amplifier unit according to the first embodiment;
FIG. 29 is a timing chart showing transition of each signal of the sense amplification part, transition of each signal of the latch circuit SDL, transition of a voltage level of the bus LBUS, transition of a voltage level at the node SEN, and transition of a voltage level at the node LAT_S of the latch circuit SDL in the semiconductor storage device according to the first embodiment;
FIG. 30 is a flowchart showing a procedure of a process performed by a sequencer according to a further embodiment of the first embodiment;
FIG. 31 is a diagram showing transition of a voltage level of a node SEN and transition of data held by a node LAT_S of a latch circuit SDL according to the further embodiment of the first embodiment;
FIG. 32 is a flowchart showing a procedure of a process performed by a sequencer according to a second embodiment;
FIG. 33 is a diagram showing transition of a voltage level of a node SEN and transition of data held by a node LAT_S of a latch circuit SDL according to the second embodiment; and
FIG. 34 is a cross-sectional view showing a cross-sectional structure of a semiconductor storage device according to another embodiment.

### DETAILED DESCRIPTION

In general, according to the embodiment, a semiconductor storage device includes a plurality of memory strings including a plurality of memory cell transistors, a plurality of bit lines respectively connected to the plurality of memory strings, a plurality of sense amplifier units respectively connected to the plurality of bit lines, and a control circuit configured to perform a read operation including a first process and a second process. The sensor amplifier unit includes a sense node that is connected to the memory cell transistor via the bit line, a sense amplification part configured to convert a voltage at the sense node into data, and a latch circuit configured to hold the data converted by the sense amplification part. In the first process, the control circuit senses data held by the memory cell transistor using a first sense parameter to supply a first voltage to the sense node via the bit line, converts the first voltage at the sense node into first read data by the sense amplification part to be held by the latch circuit, senses the data held by the memory cell transistor using a second sense parameter to supply a second voltage to the sense node via the bit line, generates first difference data in the latch circuit based on the first read data held by the latch circuit and the second voltage held by the sense node, counts a first cell count based on the first difference data held by the latch circuit of each of the plurality of sense amplifier units, restores the first read data to the latch circuit, senses the data held by the memory cell transistor using a third sense parameter to supply a third voltage to the sense node via the bit line, generates second difference data in the latch circuit based on the first read data restored to the latch circuit and the third voltage held by the sense node, counts a second cell count based on the second difference data held by the latch circuit of each of the plurality of sense amplifier units, acquires a third cell count by computing a difference between the first cell count and the second cell count, and determines which of the first sense parameter, the second sense parameter, and the third sense parameter is used as a selected sense parameter based on the first cell count and the third cell count. In the second process, the control circuit reads data from the memory cell transistor using the selected sense parameter determined in the first process.

An embodiment will be described below with reference to the accompanying drawings. To facilitate understanding of the description, the same components in different drawings are denoted by the same reference signs whenever possible and redundant description thereof will be omitted.

### 1 First Embodiment

The semiconductor storage device according to the first embodiment will be described. The semiconductor storage device according to the present embodiment is a nonvolatile storage device configured as a NAND flash memory.

### 1.1 Configuration of memory system

First, a configuration of a memory system according to the present embodiment will be described.

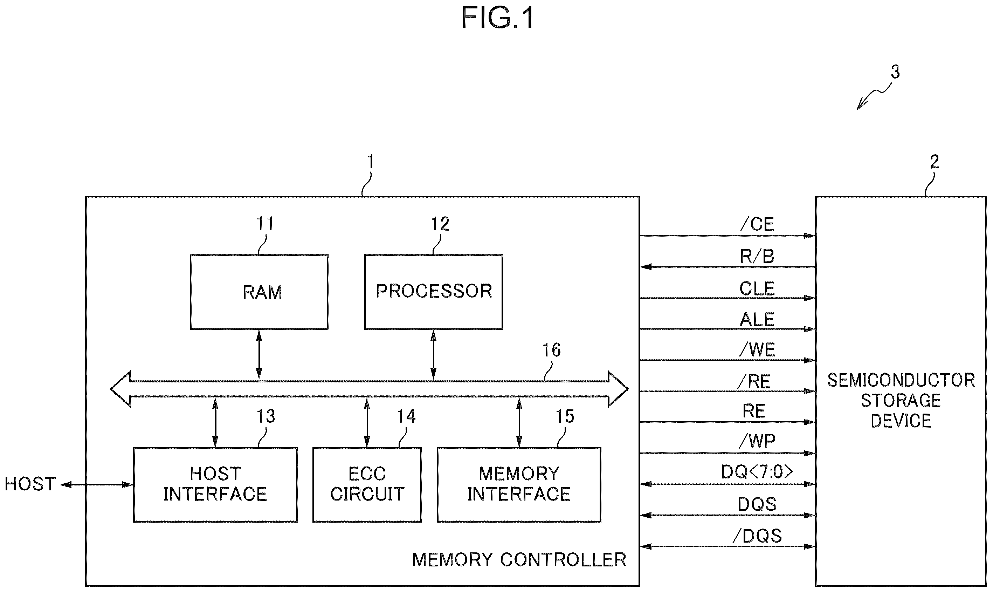

As shown in FIG. 1, the memory system 3 according to the present embodiment includes a memory controller 1 and a semiconductor storage device 2. The memory system 3 is connectable to a host. The host is an electronic device such as a personal computer or a portable terminal.

The memory controller 1 controls writing of data into the semiconductor storage device 2 (also referred to as a program) in response to a write request from the host. The memory controller 1 also controls reading of data from the semiconductor storage device 2 in response to a read request from the host.

Signals are exchanged between the memory controller 1 and the semiconductor storage device 2, including: a chip enable signal /CE, a ready/busy signal R/B, a command latch enable signal CLE, an address latch enable signal ALE, a write enable signal /WE, read enable signals /RE and RE, a write protect signal /WP, a signal DQ <7:0>, and data strobe signals DQS and /DQS.

The chip enable signal /CE is transmitted from the memory controller 1 to the semiconductor storage device 2. The chip enable signal /CE is intended to enable the semiconductor storage device 2. The ready/busy signal R/B is transmitted from the semiconductor storage device 2 to the memory controller 1. The ready/busy signal R/B is intended to indicate whether the semiconductor storage device 2 is in a ready state or in a busy state. The "ready state" is a state in which instructions are accepted from outside, for example. The "busy state" is a state in which instructions are not accepted from outside, for example.

The command latch enable signal CLE is transmitted from the memory controller 1 to the semiconductor storage device 2. The command latch enable signal CLE is intended to indicate that the signal DQ <7:0> is a command. The address latch enable signal ALE is transmitted from the memory controller 1 to the semiconductor storage device 2. The address latch enable signal ALE is intended to indicate that the signal DQ <7:0> is an address. The write enable signal /WE is transmitted from the memory controller 1 to the semiconductor storage device 2. The write enable signal /WE is intended to take a received signal into the semiconductor storage device 2 and is asserted each time the memory controller 1 receives a command, an address, and data. The memory controller 1 instructs the semiconductor storage device 2 to take in the signal DQ <7:0> while the write enable signal /WE is at logic low.

The read enable signal /RE is transmitted from the memory controller 1 to the semiconductor storage device 2. The signal RE is a complementary signal of the signal /RE. The read enable signals /RE and RE are intended for the memory controller 1 to read data from the semiconductor storage device 2. The read enable signals /RE and RE are used to control operation timing of the semiconductor storage device 2 during output, for example, of the signal DQ <7:0>. The signal DQ <7:0> is a substance of data exchanged between the semiconductor storage device 2 and the memory controller 1, and includes a command, an address, and data. The data strobe signal DQS is a timing control signal exchanged between the semiconductor storage device 2 and the memory controller 1 together with the signal DQ <7:0>. The signal /DQS is a complementary signal of the signal DQS. The data strobe signals DQS and /DQS are intended to control input-output timing of the signal DQ <7:0>.

The memory controller 1 includes a RAM 11, a processor 12, a host interface 13, an ECC circuit 14, and a memory interface 15, which are interconnected via an internal bus 16.

The host interface 13 outputs a request received from the host, user data (write data), and the like to the internal bus 16. The host interface 13 is a circuit that transmits user data read out of the semiconductor storage device 2, a response from the processor 12, and the like to the host. As the host interface 13, for example, SCSI, SAS (Serial Attached SCSI), ATA, SATA (Serial ATA), PCIe (PCI Express), Ethernet (registered trademark), Fibre Channel, and NVMe (NVM Express) (registered trademark) can be used.

The memory interface 15 is a circuit that controls the process of writing user data and the like into the semiconductor storage device 2 and the process of reading user data and the like from the semiconductor storage device 2 on instructions from the processor 12. Communication between the memory interface 15 and the semiconductor storage device 2 conforms, for example, to SDR (single data rate) interface, toggle DDR (double data rate) interface, or ONFI (Open NAND flash interface) standard.

The processor 12 exerts overall control over the memory controller 1. The processor 12 is a CPU, an MPU, or the like. When a request is received from the host via the host interface 13, the processor 12 performs control according to the request. For example, in response to the request from the host, the processor 12 instructs the memory interface 15 to write user data and parity into the semiconductor storage device 2. In response to the request from the host, the processor 12 also instructs the memory interface 15 to read the user data and parity from the semiconductor storage device 2.

The processor 12 determines a storage area (memory area) on the semiconductor storage device 2 for the user data accumulated in the RAM 11. The user data is stored in the RAM 11 via the internal bus 16. The processor 12 determines the memory areas for data (page data) managed in the unit of writing, i.e., on a page-by-page basis. Hereinafter, the user data stored on one page of the semiconductor storage device 2 will also be referred to as "unit data." Generally, the unit data is encoded, and stored as code words in the semiconductor storage device 2. According to the present embodiment, encoding is not essential. The memory controller 1 may store the unit data in the semiconductor storage device 2 without encoding, but FIG. 1 shows as an example a configuration in which encoding is done.

The processor 12 determines a memory area of the semiconductor storage device 2 at the write destination for each unit data item. Physical addresses have been assigned to the memory areas of the semiconductor storage device 2. The processor 12 manages the memory areas at the write destinations for unit data using the physical addresses. By specifying determined memory areas (physical addresses), the processor 12 instructs the memory interface 15 to write user data into the semiconductor storage device 2. The processor 12 manages correspondence between logical addresses (the logical addresses managed by the host) and the physical addresses of the user data. When a read request containing a logical address from the host is received, the processor 12 identifies the physical address corresponding to the logical address and instructs the memory interface 15 to read the user data, by specifying the physical address.

The ECC circuit 14 encodes the user data stored in the RAM 11, and thereby generates code words. The ECC circuit 14 also decodes the code words read out of the semiconductor storage device 2.

The RAM 11 temporarily stores the user data received from the host, before storing the user data in the semiconductor storage device 2 and temporarily stores the data read out of the semiconductor storage device 2, before transmitting the data to the host. The RAM 11 is a general-purpose memory such as a SRAM or a DRAM.

FIG. 1 shows a configuration example in which the memory controller 1 includes the ECC circuit 14 and the memory interface 15. However, the ECC circuit 14 may be incorporated in the memory interface 15. Alternatively, the ECC circuit 14 may be incorporated in the semiconductor storage device 2. Specific configurations and arrangements of the components shown in FIG. 1 are not particularly limited.

When a write request is received from the host. the memory system 3 in FIG. 1 operates as follows. The processor 12 temporarily stores the write data in the RAM 11. The processor 12 reads the data stored in the RAM 11 and inputs the data to the ECC circuit 14. The ECC circuit 14 encodes the input data and inputs code words to the memory interface 15. The memory interface 15 writes the input code words in the semiconductor storage device 2.

When a read request is received from the host, the memory system 3 in FIG. 1 operates as follows. The memory interface 15 inputs the code words read out of the semiconductor storage device 2 to the ECC circuit 14. The ECC circuit 14 decodes the input code words and stores the resulting data in the RAM 11. The processor 12 transmits the data stored in the RAM 11 to the host via the host interface 13.

### 1.2 Schematic configuration of semiconductor storage device

Next, a schematic configuration of the semiconductor storage device 2 will be described.

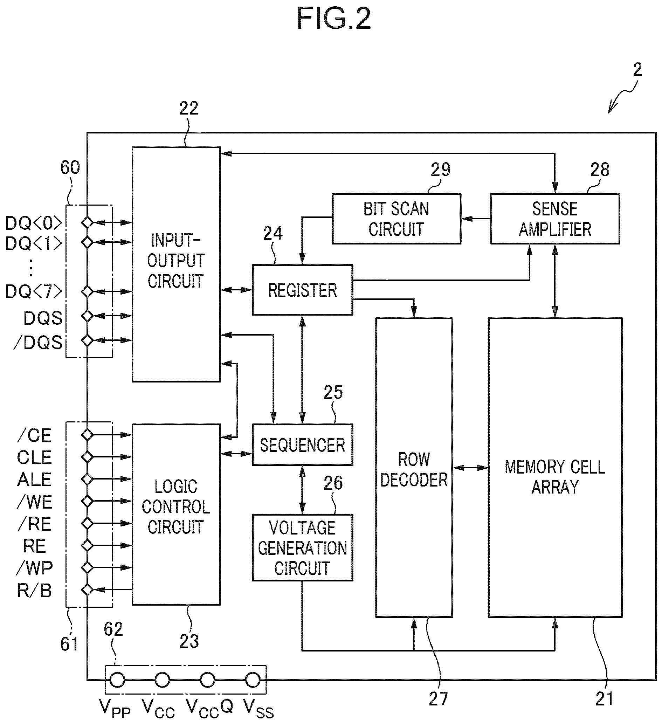

As shown in FIG. 2, the semiconductor storage device 2 includes a memory cell array 21, an input-output circuit 22, a logic control circuit 23, a register 24, a sequencer 25, a voltage generation circuit 26, a row decoder 27, a sense amplifier 28, a bit scan circuit 29, an input/output pad group 60, a logic control pad group 61, and a power input terminal group 62.

The memory cell array 21 is a part configured to store data. The memory cell array 21 includes a plurality of memory cell transistors linked to a plurality of bit lines and a plurality of word lines.

The input-output circuit 22 exchanges the signal DQ <7:0> and the data strobe signals DQS and /DQS with the memory controller 1. Also, the input-output circuit 22 transfers a command and an address in the signal DQ <7:0> to the register 24. Furthermore, the input-output circuit 22 exchanges write data and read data with the sense amplifier 28.

The logic control circuit 23 receives the chip enable signal /CE, the command latch enable signal CLE, the address latch enable signal ALE, the write enable signal /WE, the read enable signals RE and /RE, and the write protect signal /WP from the memory controller 1. The logic control circuit 23 transfers the ready/busy signal R/B to the memory controller 1 and informs the outside about the state of the semiconductor storage device 2.

The register 24 temporarily holds various types of data. For example, the register 24 holds commands for use to instruct write operations, read operations, erase operations, and other operations to be performed. The commands are inputted to the input-output circuit 22 from the memory controller 1, and then transferred from the input-output circuit 22 to the register 24 and held there. The register 24 also holds addresses corresponding to the commands. The addresses are inputted to the input-output circuit 22 from the memory controller 1, and then transferred from the input-output circuit 22 to the register 24 and held there. Furthermore, the register 24 also holds status information that represents the operating state of the semiconductor storage device 2. The status information is updated by the sequencer 25 as needed according to the operating states of the memory cell array 21 and the like. The status information is outputted as status signals from the input-output circuit 22 to the memory controller 1 in response to requests from the memory controller 1.

The sequencer 25 controls operations of various parts including the memory cell array 21 based on control signals inputted to the input-output circuit 22 and the logic control circuit 23 from the memory controller 1. According to the present embodiment, the sequencer 25 is an example of a control circuit.

The voltage generation circuit 26 is a part configured to generate respective voltages necessary for the data write operation, data read operation, and data erase operation of the memory cell array 21. The voltages include voltages and the like applied, for example, to respective ones of a plurality of word lines and plurality of bit lines of the memory cell array 21. The operation of the voltage generation circuit 26 is controlled by the sequencer 25.

The row decoder 27 is a circuit made up of a switch group for use to apply voltages to each of the plurality of word lines of the memory cell array 21. The row decoder 27 receives a block address and a row address from the register 24 and selects a block based on the block address and selects a word line based on the row address. The row decoder 27 switches the open/closed states of the switch group such that voltages will be supplied to the selected word lines from the voltage generation circuit 26. The operation of the row decoder 27 is controlled by the sequencer 25.

The sense amplifier 28 is a circuit intended to adjust the voltage applied to the bit lines of the memory cell array 21 as well as to read the voltages of the bit lines and convert the voltages into data. During a data read, the sense amplifier 28 acquires data read to the bit lines from the memory cell transistors of the memory cell array 21 and transfers the acquired read data to the input-output circuit 22. During a data write, the sense amplifier 28 transfers the data written via the bit lines to the memory cell transistors. The operation of the sense amplifier 28 is controlled by the sequencer 25.

The bit scan circuit 29 is a circuit for counting the number of memory cell transistors MT having a predetermined threshold voltage in a tracking process as one of operations for searching for an optimum read voltage. In the present embodiment, the bit scan circuit 29 is an example of a counter circuit.

The input/output pad group 60 is made up of a plurality of terminals (pads) for use to exchange various signals between the memory controller 1 and the input-output circuit 22. The terminals are provided individually for the signal DQ <7:0> and the data strobe signals DQS and /DQS.

The logic control pad group 61 is made up of a plurality of terminals for use to exchange various signals between the memory controller 1 and the logic control circuit 23. The terminals are provided individually for the chip enable signal /CE, the command latch enable signal CLE, the address latch enable signal ALE, the write enable signal /WE, the read enable signals RE and /RE, the write protect signal /WP, and the ready/busy signal R/B.

The power input terminal group 62 is made up of a plurality of terminals through which various voltages necessary for operations of the semiconductor storage device 2 are applied. The voltages applied to the respective terminals include power supply voltages VCC, VCCQ. and VPP and a ground voltage VSS. The power supply voltage VCC is a circuit power supply voltage provided externally as an operating power supply voltage and is, for example, around 2.5 V. The power supply voltage VCC is used to generate, for example, a voltage VDD, which is an internal supply voltage of the semiconductor storage device 2. The power supply voltage VDD is, for example, around 1.5 V. The power supply voltage VCCQ is lower than the power supply voltage VCC, and is, for example, 1.2 V. The power supply voltage VCCQ is an input-output power supply voltage used in exchanging signals between the memory controller 1 and the semiconductor storage device 2. The power supply voltage VPP is higher than the power supply voltage VCC and is, for example, 12 V.

### 1.3 Circuit configurations of memory cell arrays

Next, circuit configurations of the memory cell array 21 will be described.

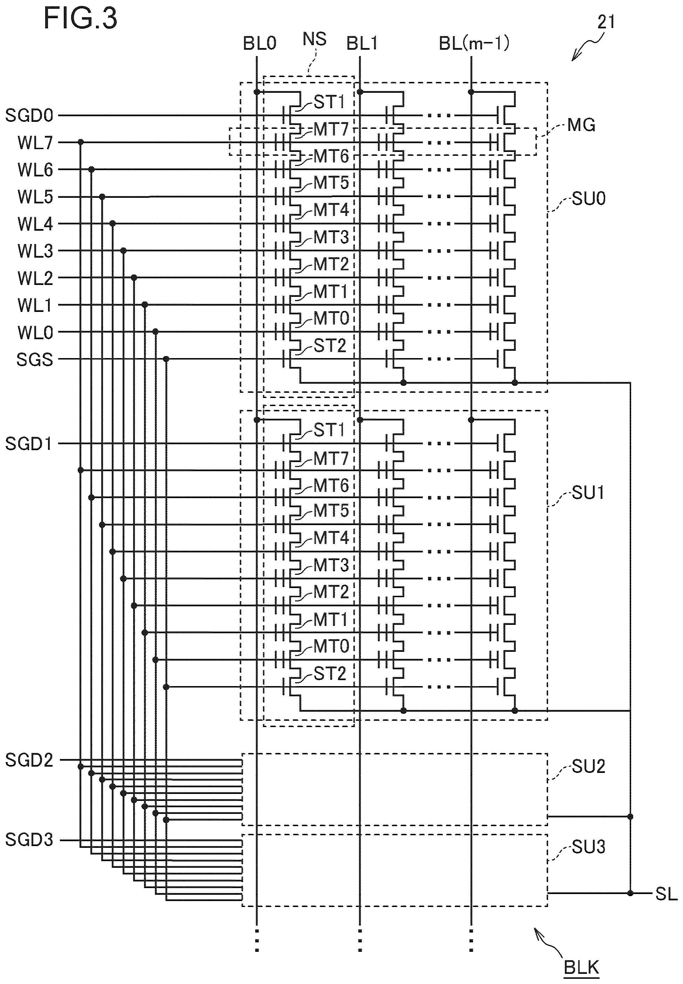

As shown in FIG. 3, the memory cell array 21 is made up of a plurality of blocks BLK. In FIG. 3, only one of the plurality of blocks BLK is illustrated. The other blocks BLK of the memory cell array 21 are similar in configuration to the block BLK shown in FIG. 3.

As shown in FIG. 3, the block BLK includes, for example, four string units SU (SU0 to SU3). Each of the string units SU includes a plurality of NAND strings NS. Each of the NAND strings NS includes, for example, eight memory cell transistors MT (MT0 to MT7) and selection transistors ST1 and ST2. In the present embodiment, a NAND string NS is an example of the memory string.

The memory cell transistors MT are placed, being connected in series between the selection transistor ST1 and the selection transistor ST2. The memory cell transistor MT7 at one end is connected to a source of the selection transistor ST1, and the memory cell transistor MT0 at the other end is connected to a drain of the selection transistor ST2. In other words, the selection transistor ST1 is connected to a drain of the memory cell transistor MT7 at one end, and the selection transistor ST2 is connected to a source of the memory cell transistor MT0 at the other end.

Gates of the selection transistors ST1 in the respective string units SU0 to SU3 are commonly connected to respective select gate lines SGDO to SGD3. The select gate lines SGDO to SGD3 are also referred to as select gate lines SGDO to SGD3 on the drain side. Gates of the selection transistors ST2 are commonly connected to the same select gate line SGS among a plurality of string units SU in the same block BLK. The select gate line SGS is also referred to as a select gate line SGS on the source side. Gates of the memory cell transistors MT0 to MT7 in the same block BLK are commonly connected to respective word lines WL0 to WL7. That is, the word lines WL0 to WL7 and the select gate line SGS are common among the plurality of string units SU0 to SU3 in the same block BLK, but the select gate lines SGD are provided individually for each of the string units SU0 to SU3 even in the same block BLK.

Bit lines BL (BL0, BL1, ..., BL(m-1)), m in number, are provided in the memory cell array 21, where "m" is an integer corresponding to the number of NAND strings NS included in one string units SU0. A drain of each selection transistor ST1 in the NAND strings NS is connected to a corresponding bit line BL. A source of each selection transistor ST2 in the NAND strings NS is connected to a source line SL. The source line SL is common to the sources of a plurality of the selection transistors ST2 in the block BLK.

Data stored in a plurality of the memory cell transistors MT in the same block BLK is erased in batches. On the other hand, data reads and data writes are performed in batches with respect to a plurality of the memory cell transistors MT that are connected to one word line WL and belong to one string unit SU.

Each of the memory cell transistors MT can hold 4-bit data made up of, for example, a highest-order bit, a high-order bit, a middle-order bit, and a low-order bit based on a threshold voltage. That is, as a method of writing data into the memory cell transistor MT, the semiconductor storage device 2 according to the present embodiment adopts a QLC system that can allow four bits of data to be stored in a single memory cell transistor MT. In place of such an aspect, as a system of writing data into the memory cell transistor MT, a TLC system that allows 3-bit data to be stored in a single memory cell transistor MT, an MLC system that allows 2-bit data to be stored in a single memory cell transistor MT, an SLC system that allows 1-bit data to be stored in a single memory cell transistor MT, or the like may be adopted.

Hereinafter, a set of one-bit data stored in a plurality of the memory cell transistors MT connected to one word line WL and belonging to one string unit SU will be referred to as a "page." In FIG. 3, one of sets of a plurality of memory cell transistors MT such as described above is marked with the reference sign "MG."

When four bits of data are stored in a single memory cell transistor MT as with the present embodiment, a set of a plurality of memory cell transistors MT connected to a word line WL common in one string unit SU can store four pages of data.

### 1.4 Sectional structure of semiconductor storage device

Next, the memory cell array 21 and a structure therearound will be described.

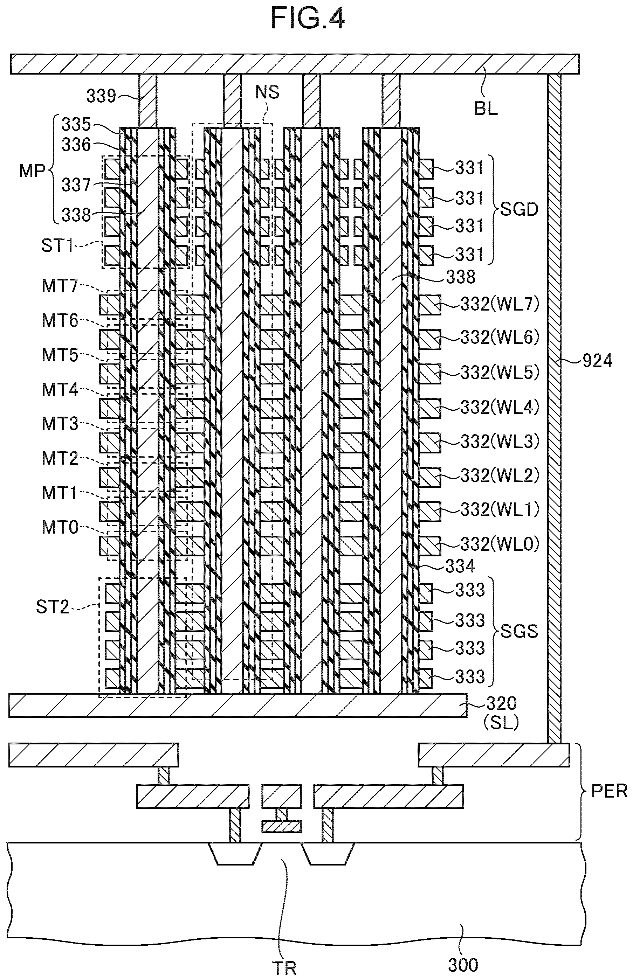

As shown in FIG. 4, in the memory cell array 21, a plurality of NAND strings NS are formed on a conductor layer 320. The conductor layer 320 is also referred to as a buried source line (BSL) and corresponds to the source line SL shown in FIG. 3.

A plurality of interconnect layers 333 functioning as the select gate line SGS, a plurality of interconnect layers 332 functioning as word lines WL, and a plurality of interconnect layers 331 functioning as a select gate line SGD are stacked above the conductor layer 320. Non-illustrated insulating layers are placed among the stacked interconnect layers 333, 332, and 331.

A plurality of memory holes 334 are formed in the memory cell array 21. The memory holes 334 penetrate vertically through the interconnect layers 333, 332, and 331 and through the non-illustrated insulating layers placed among the interconnect layers, reaching the conductor layer 320. A block insulator 335, a charge storage layer 336, and a gate insulator 337 are formed on a side face of each memory hole 334 in sequence, and moreover a conductor pillar 338 is embedded on the inner side thereof. The conductor pillar 338 is made, for example, of polysilicon, and functions as a region in which channels are formed during operation of the memory cell transistors MT and selection transistors ST1 and ST2 included in the NAND string NS. Hereinafter, a columnar body made up of the block insulator 335, the charge storage layer 336, the gate insulator 337, and the conductor pillar 338 on the inner side of each memory hole 334 will also be referred to as a memory pillar MP.

Of the memory pillar MP, parts intersecting the stacked interconnect layers 333, 332, and 331, respectively, function as transistors. Of the plurality of transistors, those located at intersections with the interconnect layers 331 function as the selection transistors ST1. Of the plurality of transistors, those located at intersections with the interconnect layers 332 function as the memory cell transistors MT (MT0 to MT7). Of the plurality of transistors, those located at intersections with the interconnect layers 333 function as the selection transistors ST2. Thanks to this configuration, the memory pillars MP function as the NAND strings NS shown in FIG. 3. The conductor pillars 338 located on the inner side of the memory pillars MP function as channels of the memory cell transistors MT or selection transistors ST1 and ST2. Each of intersection points of the memory pillars MP and the interconnect layers 331 functions as the selection transistor ST1. Each of intersection points of the memory pillars MP and the interconnect layers 332 functions as the memory cell transistor MT. Each of intersection points of the memory pillars MP and the interconnect layers 333 functions as the selection transistor ST2. A threshold voltage of each of the memory cell transistors MT varies in accordance with an amount of electric charges (electrons) held by a corresponding charge storage layer 336. In a write operation, electric charges (electrons) of an amount corresponding to data to be held by the memory cell transistor MT are injected into the charge storage layer 336 of each of the memory cell transistors MT.

An interconnect layer functioning as a bit line BL is formed above the conductor pillars 338. Contact plugs 339 connecting the conductor pillars 338 with the bit line BL are formed on upper ends of the conductor pillars 338.

A plurality of structures with a configuration similar to the one shown in FIG. 4 are arranged in the direction away from the viewer in FIG. 4. A set of the plurality of NAND strings NS lined up in the direction away from the viewer in FIG. 4 makes up one string unit SU.

In the semiconductor storage device 2 according to the present embodiment, peripheral circuitry PER is provided below the memory cell array 21, i.e., in a location between the memory cell array 21 and a semiconductor substrate 300. The peripheral circuitry PER is provided to implement data write, data read, data erase, and other operations in the memory cell array 21. The voltage generation circuit 26, the row decoder 27, the sense amplifier 28, the bit scan circuit 29, and the like shown in FIG. 2 are part of a peripheral circuit PER. The peripheral circuitry PER includes various types of transistors, RC circuits, and the like. In the example shown in FIG. 4, transistors TR formed on the semiconductor substrate 300 and the bit line BL located above the memory cell array 21 are electrically connected with each other via a contact 924.

### 1.5 Configuration of sense amplifier

Next, a configuration of a sense amplifier unit SAU will be described.

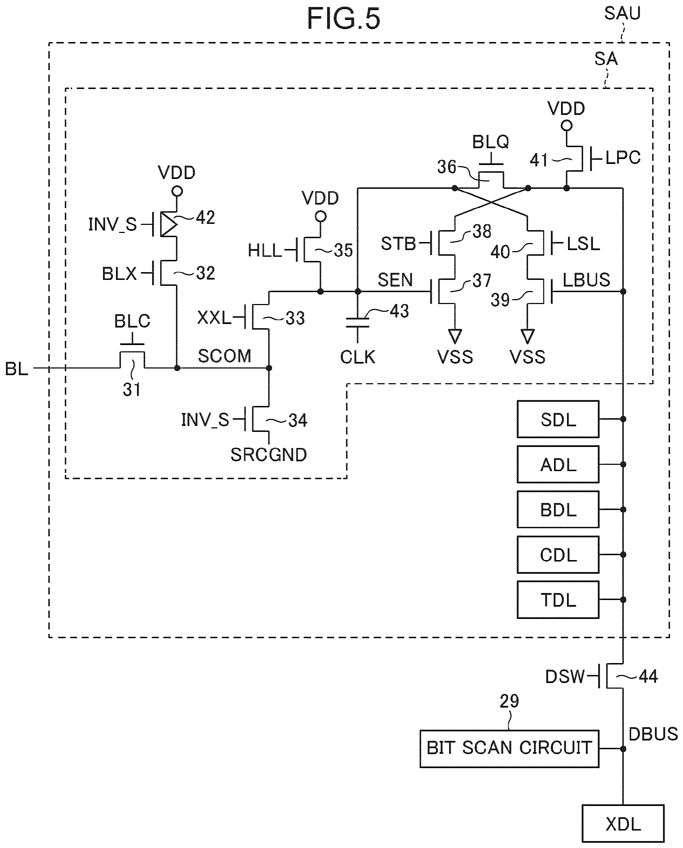

The sense amplifier 28 includes the plurality of sense amplifier units respectively associated with the plurality of bit lines BL. FIG. 5 shows a circuit configuration of one sense amplifier unit SAU that is extracted from the plurality of sense amplifier units. As shown in FIG. 5, the sense amplifier unit SAU includes a sense amplification part SA and latch circuits SDL, ADL, BDL, CDL, and TDL that are connected with each other to allow data to be exchanged therebetween.

As shown in FIG. 5, the sense amplifier unit SAU includes the sense amplification part SA and the three latch circuits SDL, ADL, BDL, CDL, and TDL. The sense amplification part SA is connected with the latch circuits SDL, ADL, BDL, CDL, and TDL via the bus LBUS.

The sense amplification part SA senses data read to the bit line BL, and applies a voltage to the bit line BL in accordance with program data. That is, the sense amplification part SA is a module that directly controls the bit line BL. The sense amplification part SA is also a module that performs AND operation or OR operation using data in the latch circuits SDL, ADL, BDL, CDL, and TDL.

Next, details about a circuit of the sense amplification part SA will be described. In the following description, one of a source and a drain of a transistor is referred to as "one end of a current path", and the other one of the source and the drain is referred to the "other end of the current path".

As shown in FIG. 5, the sense amplification part SA includes n-channel MOS transistors 31 to 41, a p-channel MOS transistor 42, and a capacitor element 43.

One end of a current path of the transistor 31 is connected to the corresponding bit line BL. The other end of the current path of the transistor 31 is connected to a node SCOM. A signal BLC generated by the sequencer 25 is input to a gate of the transistor 31.

One end of a current path of the transistor 32 is connected to the node SCOM. The other end of the current path of the transistor 32 is connected to one end of the transistor 42. A signal BLX generated by the sequencer 25 is input to a gate of the transistor 32. A power supply voltage VDD is applied to the other end of the transistor 42. A gate of the transistor 42 is connected to a node INV_S of the latch circuit SDL described later.

One end of a current path of the transistor 33 is connected to the node SCOM. The other end of the current path of the transistor 33 is connected to a node SEN. A signal XXL generated by the sequencer 25 is input to a gate of the transistor 33. One end of a current path of the transistor 34 is connected to the node SCOM. The other end of the current path of the transistor 34 is connected to a node SRCGND. A ground voltage VSS, for example, is applied to the node SRCGND. A gate of the transistor 34 is connected to the node INV_S of the latch circuit SDL described later. In the present embodiment, the node SEN is an example of the sense node.

One end of a current path of the transistor 35 is connected to the node SEN. The power supply voltage VDD is input to the other end of the current path of the transistor 35. A signal HLL generated by the sequencer 25 is input to a gate of the transistor 35.

An electrode at one end of the capacitor element 43 is connected to the node SEN. A clock CLK is input to an electrode at the other end of the capacitor element 43.

One end of a current path of the transistor 36 is connected to the node SEN. The other end of the current path of the transistor 36 is connected to the bus LBUS. A signal BLQ generated by the sequencer 25 is input to a gate of the transistor 36.

One end of a current path of the transistor 37 is connected to one end of a current path of the transistor 38. The ground voltage VSS is applied to the other end of the current path of the transistor 37. A gate of the transistor 37 is connected to the node SEN. The other end of the current path of the transistor 38 is connected to the bus LBUS. A signal STB generated by the sequencer 25 is input to a gate of the transistor 38.

One end of a current path of the transistor 39 is connected to one end of a current path of the transistor 40. The ground voltage VSS is applied to the other end of the current path of the transistor 39. A gate of the transistor 39 is connected to the bus LBUS. The other end of the current path of the transistor 40 is connected to the node SEN. A signal LSL generated by the sequencer 25 is input to a gate of the transistor 40.

One end of the transistor 41 is connected to the bus LBUS. The power supply voltage VDD is applied to the other end of the transistor 41. A signal LPC generated by the sequencer 25 is input to a gate of the transistor 41. In the sense amplification part SA, when the transistor 41 is turned on, the power supply voltage VDD is supplied to the bus LBUS, so that the bus LBUS is precharged.

The latch circuits SDL, ADL, BDL, CDL, and TDL temporarily hold data. In a data write operation, the sense amplification part SA controls the bit line BL corresponding to data held by the latch circuit SDL. The other latch circuits ADL, BDL, CDL, and TDL temporarily hold data of each bit when the individual memory cell transistor MT holds four pieces of data, for example, and the latch circuit SDL is also used in the same manner. The number of the latch circuits can be optionally set, and is set corresponding to a data amount (the number of bits) that can be held by the memory cell transistor MT, for example.

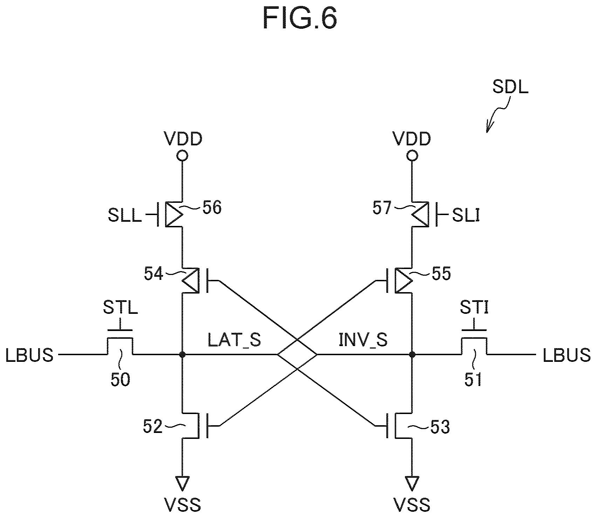

FIG. 6 is a circuit diagram showing a circuit configuration of the latch circuit SDL. As shown in FIG. 6, the latch circuit SDL includes n-channel MOS transistors 50 to 53, and p-channel MOS transistors 54 to 57.

One end of a current path of the transistor 50 is connected to the bus LBUS. The other end of the current path of the transistor 50 is connected to the node LAT_S. A signal STL generated by the sequencer 25 is input to a gate of the transistor 50. One end of a current path of the transistor 51 is connected to the bus LBUS. The other end of the current path of the transistor 51 is connected to the node INV_S. A signal STI generated by the sequencer 25 is input to a gate of the transistor 51.

One end of a current path of the transistor 52 is connected to the node LAT_S. The ground voltage VSS is applied to the other end of the current path of the transistor 52. A gate of the transistor 52 is connected to the node INV_S. One end of a current path of the transistor 53 is connected to the node INV_S. The ground voltage VSS is applied to the other end of the current path of the transistor 53. A gate of the transistor 53 is connected to the node LAT_S.

One end of a current path of the transistor 54 is connected to the node LAT_S. The other end of the current path of the transistor 54 is connected to one end of a current path of the transistor 56. A gate of the transistor 54 is connected to the node INV_S. The power supply voltage VDD is applied to the other end of the transistor 56. A signal SLL generated by the sequencer 25 is input to a gate of the transistor 56.

One end of a current path of the transistor 55 is connected to the node INV_S. The other end of the current path of the transistor 55 is connected to one end of a current path of the transistor 57. A gate of the transistor 55 is connected to the node LAT_S. The power supply voltage VDD is applied to the other end of the current path of the transistor 57. A signal SLI generated by the sequencer 25 is input to a gate of the transistor 57.

In the latch circuit SDL, a first inverter is made up of the transistors 52 and 54, and a second inverter is made up of the transistors 53 and 55. Output of the first inverter and input of the second inverter, that is, the node LAT_S, is connected to the bus LBUS via the transistor 50 for data transfer. Input of the first inverter and output of the second inverter, that is, the node INV_S, is connected to the bus LBUS via the transistor 51 for data transfer. The latch circuit SDL holds data at the node LAT_S, and holds inverted data thereof at the node INV_S.

The other latch circuits ADL, BDL, CDL, and TDL have the same configuration as that of the latch circuit SDL, so that description thereof will not be repeated. In each of the sense amplifier units SAU, the sense amplification part SA and the five latch circuits SDL, ADL, BDL, CDL, and TDL are connected with each other via the bus LBUS to allow data to be exchanged therebetween.

As shown in FIG. 5, the bus LBUS is connected to a bus DBUS via an n-channel MOS transistor 44. One end of a current path of the transistor 44 is connected to the bus LBUS. The other end of the current path of the transistor 44 is connected to the bus DBUS. A signal DSW generated by the sequencer 25 is input to a gate of the transistor 44. When the transistor 44 is turned on, the bus LBUS is connected with the bus DBUS.

The bit scan circuit 29 shown in FIG. 2 is connected to the bus DBUS. The bit scan circuit 29 scans (detects) a data holding state of the latch circuit SDL, for example. The bit scan circuit 29 includes a counter circuit, for example. In a tracking process as one of operations for searching for an optimum read voltage, the bit scan circuit 29 counts the number of the memory cell transistors MT having a predetermined threshold voltage by scanning data held by the latch circuit SDL of each of the sense amplifier units SAU.

A latch circuit XDL is connected to the bus DBUS. The latch circuit XDL is used for data input/output between the input-output circuit 22 of the semiconductor storage device 2 and the sense amplifier unit SAU.

### 1.6 Threshold voltage distribution of QLC memory cell transistor

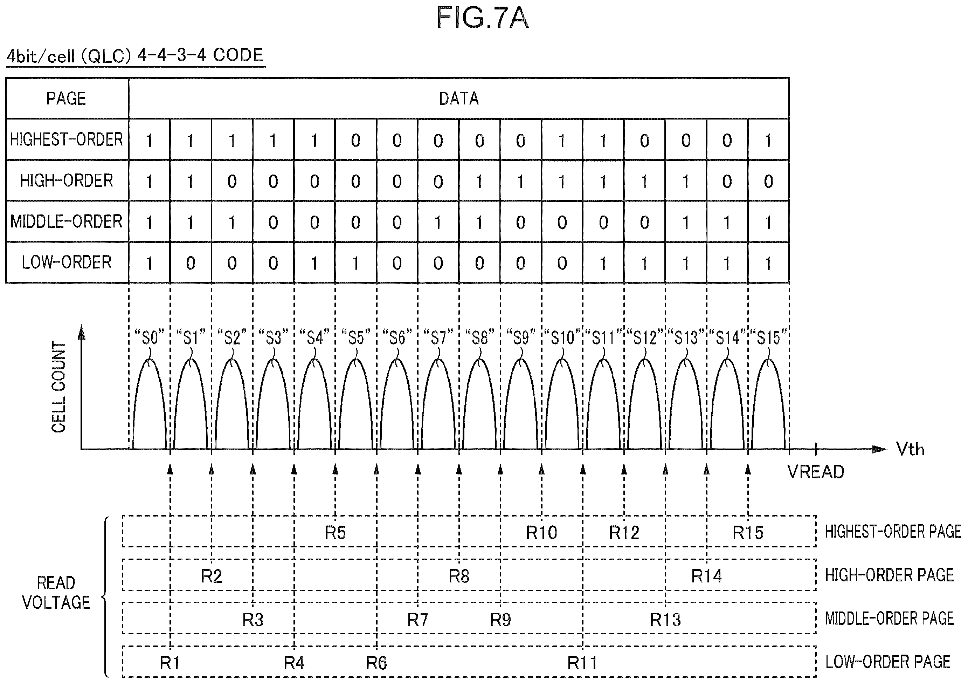

Next, the following describes threshold voltage distribution of the memory cell transistor MT to which a QLC system is applied. FIG. 7A is a diagram showing an example of distribution of threshold voltage Vth of the QLC memory cell transistor MT, data coding, and the like. Hereinafter, distribution of the threshold voltage Vth is referred to as "threshold distribution". A diagram in a middle row of FIG. 7A shows a correspondence relation between the threshold voltage Vth of the memory cell transistor MT (horizontal axis) and the number of the memory cell transistors MT (vertical axis).

As shown in FIG. 7A, the threshold distribution of the memory cell transistor MT to which the QLC system is applied is classified into sixteen types. The sixteen types of threshold distribution in the QLC system are referred to as, for example, "S0" state, "S1" state, "S2" state, "S3" state, "S4" state, "S5" state, "S6" state, "S7" state, "S8" state, "S9" state, "S10" state, "S11" state, "S12" state, "S13" state, "S14" state, and "S15" state in ascending order of the threshold voltage Vth. To each of the sixteen types of threshold distribution, for example, the following 4-bit data is assigned.

(Example) state name: "(low-order bit/middle-order bit/high-order bit/highest-order bit)" data
"S0" state: "1111" data
"S1" state: "0111" data
"S2" state: "0101" data
"S3" state: "0001" data
"S4" state: "1001" data
"S5" state: "1000" data
"S6" state: "0000" data
"S7" state: "0100" data
"S8" state: "0110" data
"S9" state: "0010" data
"S10" state: "0011" data
"S11" state: "1011" data
"S12" state: "1010" data
"S13" state: "1110" data
"S14" state: "1100" data
"S15" state: "1101" data.

A read voltage is set between adjacent threshold distributions. The "read voltage" is a voltage applied to a word line WL connected to the memory cell transistor MT as a read target, that is, a selected word line, at the time of a read operation. In the read operation, data is determined based on a result of determination whether the threshold voltage of the memory cell transistor MT as a read target is higher than the applied read voltage.

For example, a read voltage R1 is set between the "S0" state and the "S1" state. A read voltage R2 is set between the "S1" state and the "S2" state. A read voltage R3 is set between the "S2" state and the "S3" state. Hereinafter, each of read voltages R4, R5, R6, R7, R8, R9, R10, R11, R12, R13, R14, and R15 is similarly set between two adjacent states. A read pass voltage VREAD is set to a voltage higher than the "S15" state. The memory cell transistor MT having a gate to which the read pass voltage VREAD is applied is turned on irrespective of stored data.

When the data assignment described above is applied, one-page data constituted of low-order bits (hereinafter, low-order page data) is defined by a read operation using the read voltages R1, R4, R6, and R11. One-page data constituted of middle-order bits (hereinafter, middle-order page data) is defined by a read operation using the read voltages R3, R7, R9, and R13. One-page data constituted of high-order bits (hereinafter, high-order page data) is defined by a read operation using the read voltages R2, R8, and R14. One-page data constituted of highest-order bits (hereinafter, highest-order page data) is defined by a read operation using the read voltages R5, R10, R12, and R15.

Such data assignment is referred to as, for example, "4-4-3-4 code" because the low-order page data, the middle-order page data, the high-order page data, and the highest-order page data are respectively defined by four times, four times, three times, and four times of reading. The present specification exemplifies a case in which "4-4-3-4 code" is applied to data assignment of the memory cell transistor MT.

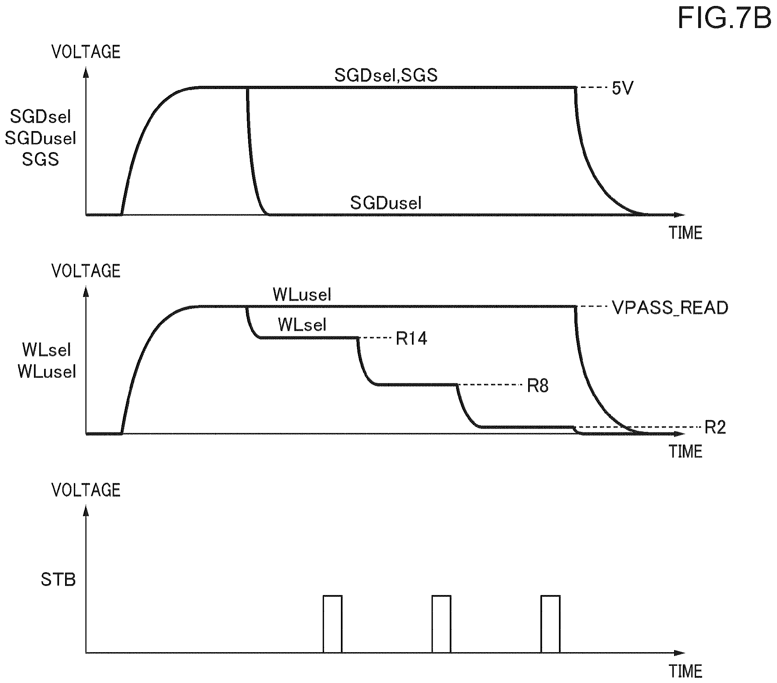

FIG. 7B shows an example of voltage variation in each piece of wiring at the time of read operation (normal read operation) for the high-order page data of the memory cell transistor MT shown in FIG. 7A. At the time of the read operation for the high-order page, as shown in FIG. 7B, the read voltage R14, read voltage R8, and the read voltage R2 are applied to a selected word line WLsel in order from the voltage generation circuit 26 via the row decoder 27 for a predetermined time.

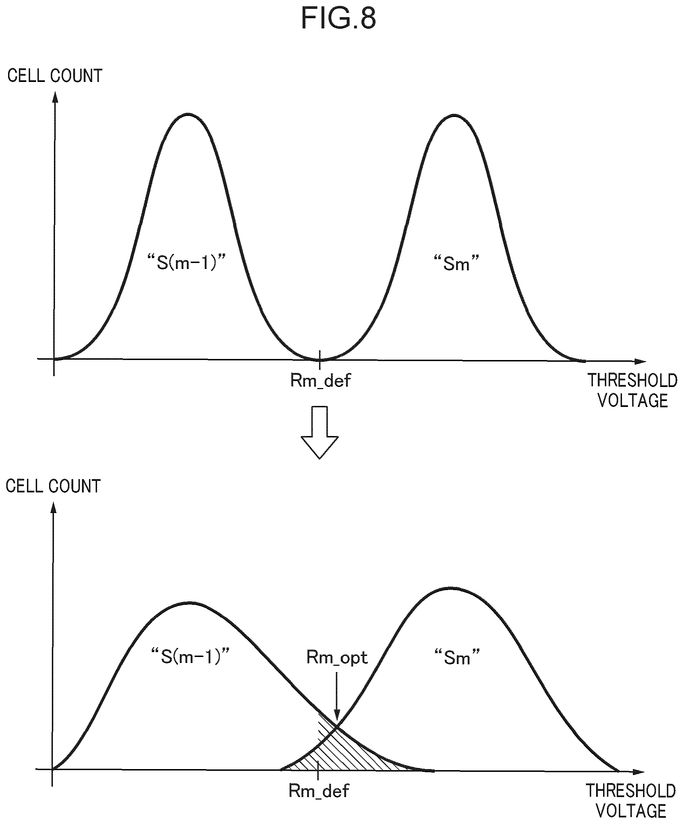

As shown in a graph of an upper row in FIG. 8, threshold distributions of "S(m-1)" state and "Sm" state are deviated from each other immediately after writing. Herein, m is an integer equal to or larger than 1 and equal to or smaller than 15. The memory controller 1 can read correct data by setting a read voltage Rm to a predefined read voltage Rm_def between the threshold distributions of the "S(m-1)" state and the "Sm" state.

However, the threshold voltage Vth of the memory cell transistor MT may vary. This is because a state of electric charges (electrons) injected into the charge storage film 336 (refer to FIG. 4) varies with passage of time due to a write operation, for example. A state in which a long period has elapsed after the write operation on the memory cell transistor MT is referred to as data retention. Due to a factor such as data retention, a distribution width of the threshold voltage Vth in each state may be increased, or a mode of the threshold distribution in each state is changed, for example. As a result, as shown in a graph of a lower row in FIG. 8, adjacent distributions may overlap with each other. In a case where the adjacent distributions overlap with each other, when a read operation is performed by using the read voltage Rm_def, data that is different from the data at the time of writing is read from the memory cell transistor MT corresponding to a hatched part in the graph of the lower row in FIG. 8. More specifically, in the threshold distribution of the "S(m-1)" state, an error occurs in read data of the memory cell transistor MT having the threshold voltage Vth equal to or larger than the read voltage Rm_def. In the threshold distribution of the "Sm" state, an error occurs in read data of the memory cell transistor MT having the threshold voltage Vth smaller than the read voltage Rm_def. To minimize occurrence of such an error, it is preferable to perform the read operation using an optimum read voltage Rm_opot that minimizes an area of the hatched part in the graph of the lower row in FIG. 8. Hereinafter, the optimum read voltage of each state is represented by appending "opt" to its end.

In the semiconductor storage device 2 according to the present embodiment, a tracking process for searching for an optimum read voltage Rm_opt (R1_opt to R15_opt) is performed so as to read data. Specifically, in the semiconductor storage device 2 according to the present embodiment, an adjustment read operation including the tracking process for searching for the optimum read voltage Rm_opt and a read process of reading data from the memory cell transistor MT using the searched read voltage Rm_opt can be performed in addition to the normal read operation including a read process of reading data from the memory cell transistor MT. In the present embodiment, the tracking process is an example of the first process, and the read process is an example of the second process. That is, the semiconductor storage device 2 according to the present embodiment can perform the normal read operation including only the read process (second process), and the adjustment read operation including the tracking process (first process) and the read process (second process).

In the semiconductor storage device 2, for example, when a write operation is performed, the adjustment read operation may be performed while the write operation is temporarily suspended, that is, during a suspension of the write operation. During the suspension of the write operation, in the sense amplifier unit SAU shown in FIG. 5, there is a possibility that data corresponding to the write operation is held by the latch circuits ADL, BDL, CDL, and TDL. In such a case, in the sense amplifier unit SAU, only the latch circuit SDL can be substantially used, so that there is a demand for performing the adjustment read operation using only one latch circuit SDL. In particular, there is a demand for performing, during a suspension of the write operation, the tracking process using only the latch circuit SDL (one latch circuit) that can be used by the sense amplifier unit SAU. In the semiconductor storage device 2 according to the present embodiment, the tracking process for searching for the optimum read voltage Rm_opt described above is enabled to be performed in a situation in which only one such latch circuit SDL can be used. The following specifically describes the adjustment read operation in the present embodiment.

### 1.7 Adjustment read operation

Before specifically describing the adjustment read operation in the present embodiment, the following describes a principle of the tracking process (first process) for searching for the optimum read voltage Rm_opt.

In the tracking process in the present embodiment, for example, the optimum read voltage Rm_opt is selected from among the predefined read voltage Rm_def, a read voltage "Rm_def - VCG" that is lower than the predefined read voltage Rm_def by a predetermined value VCG, and a read voltage "Rm_def + VCG" that is higher than the predefined read voltage Rm_def by the predetermined value VCG.

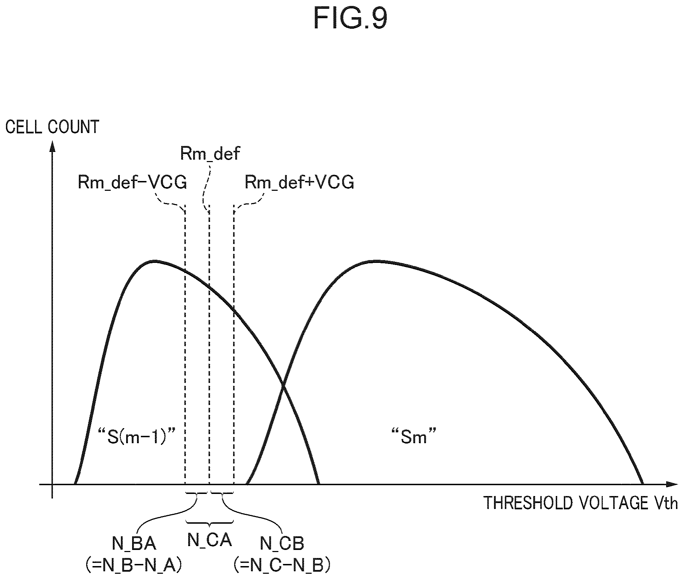

For example, it is assumed that the respective threshold distributions of the "S(m-1)" state and the "Sm" state have varied as shown in FIG. 9 with respect to the read voltages Rm_def, Rm_def - VCG, and Rm_def + VCG. In this case, assuming that the number of memory cells to be turned on in a read process using the read voltage "Rm_def - VCG" is an on-cell count N_A, and the number of memory cells to be turned on in a read process using the read voltage Rm_def is an on-cell count N_B, an on-cell count N_BA with which the threshold voltage Vth satisfies "Rm_def - VCG < Vth ≤ Rm_def" can be computed by "N_B - N_A". Additionally, assuming that the number of memory cells to be turned on in a read process using the read voltage "Rm_def + VCG" is an on-cell count N_C, an on-cell count N_CB with which the threshold voltage Vth satisfies "Rm_def < Vth ≤ Rm_def + VCG" can be computed by "N_C - N_B". In the tracking process in the present embodiment, the optimum read voltage Rm_opt is set by using these on-cell counts N_BA and N_CB.

Specifically, when the respective threshold distributions of the "S(m-1)" state and the "Sm" state vary in a form as shown in FIG. 9, the on-cell count N_BA and the on-cell count N_CB satisfy "N_CB - N_BA < -p1". Herein, p1 is an optional threshold satisfying "p1 > 0". In this case, by using the read voltage "Rm_def + VCG" among the three read voltages Rm_def, Rm_def - VCG, and Rm_def + VCG, it is possible to minimize the number of the memory cell transistors MT in which an error occurs in read data. Thus, it is optimum to use the read voltage "Rm_def + VCG" as the optimum read voltage Rm_opt.

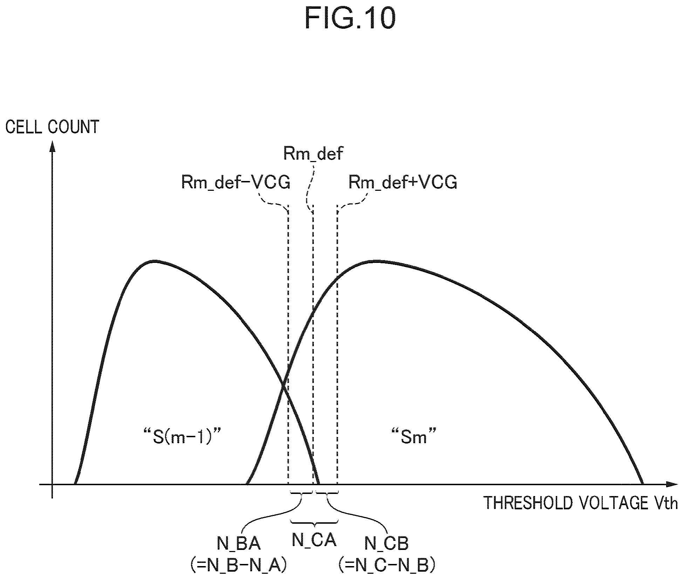

When the respective threshold distributions of the "S(m-1)" state and the "Sm" state vary in a form as shown in FIG. 10, the on-cell count N_BA and the on-cell count N_CB satisfy "p2 < N_CB - N_BA". Herein, p2 is an optional threshold satisfying "p2 > 0". The threshold p2 may be the same value as the threshold p1, or may be a value different from the threshold p1. In this case, by using the read voltage "Rm_def - VCG" among the three read voltages Rm_def, Rm_def - VCG, and Rm_def + VCG, it is possible to minimize the number of the memory cell transistors MT in which an error occurs in read data. Thus, it is optimum to use the read voltage "Rm_def - VCG" as the optimum read voltage Rm_opt.

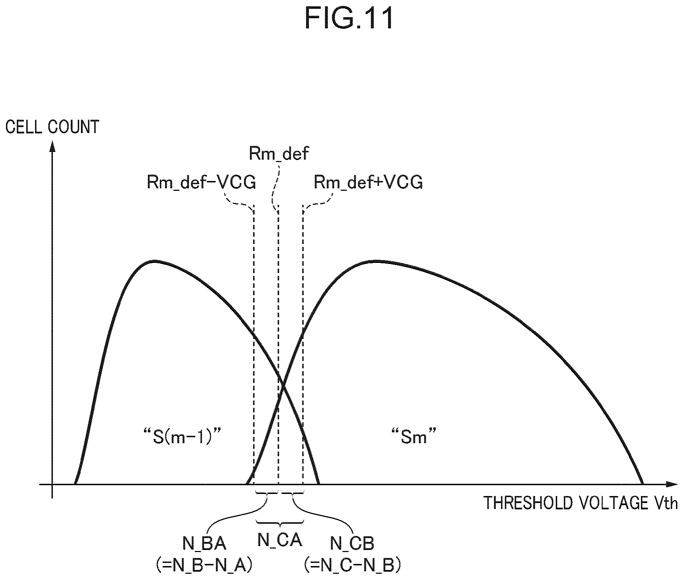

Furthermore, when the respective threshold distributions of the "S(m-1)" state and the "Sm" state vary in a form as shown in FIG. 11, the on-cell count N_BA and the on-cell count N_CB satisfy "-p1 ≤ N_CB - N_BA ≤ p2". In this case, by using the read voltage Rm_def among the three read voltages Rm_def, Rm_def - VCG, and Rm_def + VCG, it is possible to minimize the number of the memory cell transistors MT in which an error occurs in read data. Thus, it is optimum to use the read voltage Rm_def as the optimum read voltage Rm_opt.

In the present embodiment, the read voltage "Rm_def - VCG" is an example of the first sense parameter, and the read voltage "Rm_def" is an example of the second sense parameter. The "Rm_def + VCG" is an example of the third sense parameter, and the optimum read voltage Rm_opt is an example of the selected sense parameter.

In a case of the QLC, the read voltage R15 set between the highest-order "S15" state and the "S14" state lower than the "S15" state may be used as the read voltage "Rm_def". Alternatively, a voltage R15 - VCG may be used as the read voltage "Rm_def - VCG", and a voltage R15 + VCG may be used as the read voltage "Rm_def + VCG". In this case, the voltage R15 - VCG applied to the selected word line WLsel is the first sense parameter, the voltage R15 applied to the selected word line WLsel is the second sense parameter, and the voltage R15 + VCG applied to the selected word line WLsel is the third sense parameter.

The first sense parameter, the second sense parameter, and the third sense parameter can be appropriately changed. For example, a first sense time may be used as the first sense parameter, a second sense time longer than the first sense time may be used as the second sense parameter, and a third sense time longer than the second sense time may be used as the third sense parameter. The sense time is a time for setting the signal XXL to "H" level after the node SEN is charged in the sense amplification part SA. It can also be considered that the sense time is a time for electrically connecting the node SEN to the bit line BL after the node SEN is charged in the sense amplification part SA. More specifically, in a state in which the voltage R15 is applied to the selected word line WLsel, the sense amplification part SA may be operated to perform a sense operation for the first sense time, the second sense time, and the third sense time. In this case, the first sense time is the first sense parameter, the second sense time is the second sense parameter, and the third sense time is the third sense parameter.

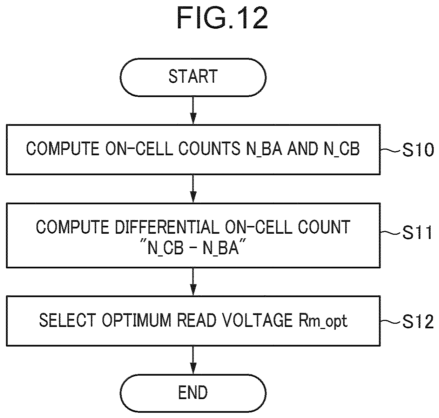

By using the principle as described above, the sequencer 25 in the present embodiment performs a computation process of the optimum read voltage Rm_opt using a procedure as shown in FIG. 12.

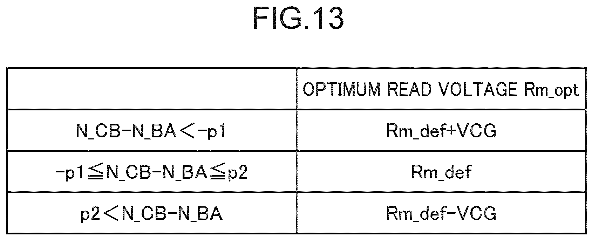

As shown in FIG. 12, first, the sequencer 25 computes the on-cell counts N_BA and N_CB (Step S10), and computes a differential on-cell count "N_CB - N_BA" based on the computed on-cell counts N_BA and N_CB (Step S11). The sequencer 25 also selects the optimum read voltage Rm_opt from among the three read voltages Rm_def, Rm_def - VCG, and Rm_def + VCG in a form as shown in FIG. 13 based on the differential on-cell count "N_CB - N_BA" (Step S12). The sequencer 25 then performs a read process corresponding to the read voltage Rm using the optimum read voltage Rm_opt.

On the other hand, to determine the optimum read voltage Rm_opt using the process as shown in FIG. 12, the on-cell counts N_BA and N_CB need to be computed. In the semiconductor storage device 2 according to the present embodiment, these on-cell counts N_BA and N_CB are computed by using one latch circuit SDL. Next, the following describes a specific procedure of the adjustment read operation using such a method.

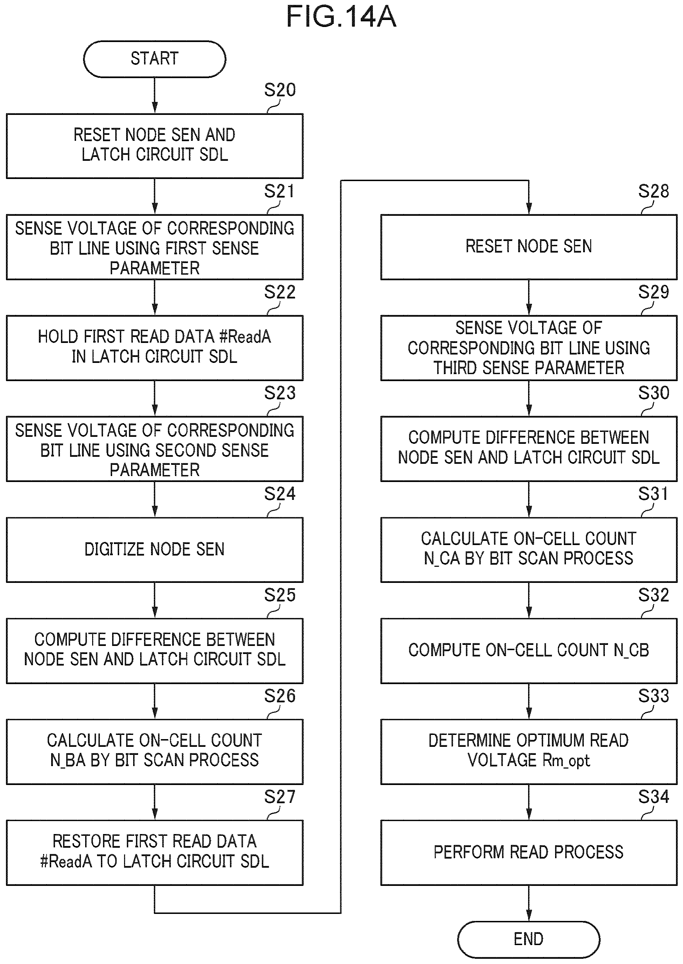

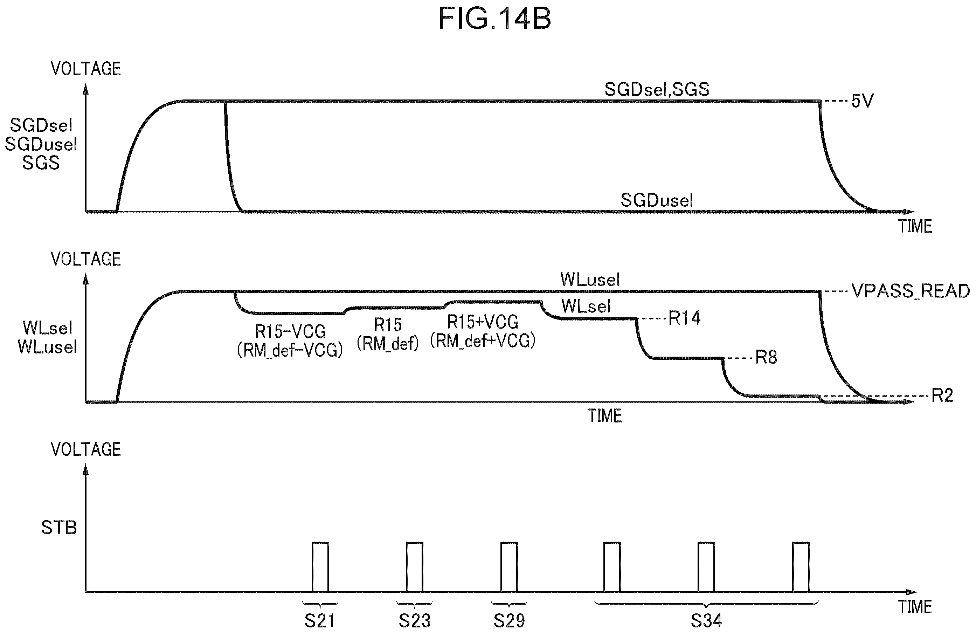

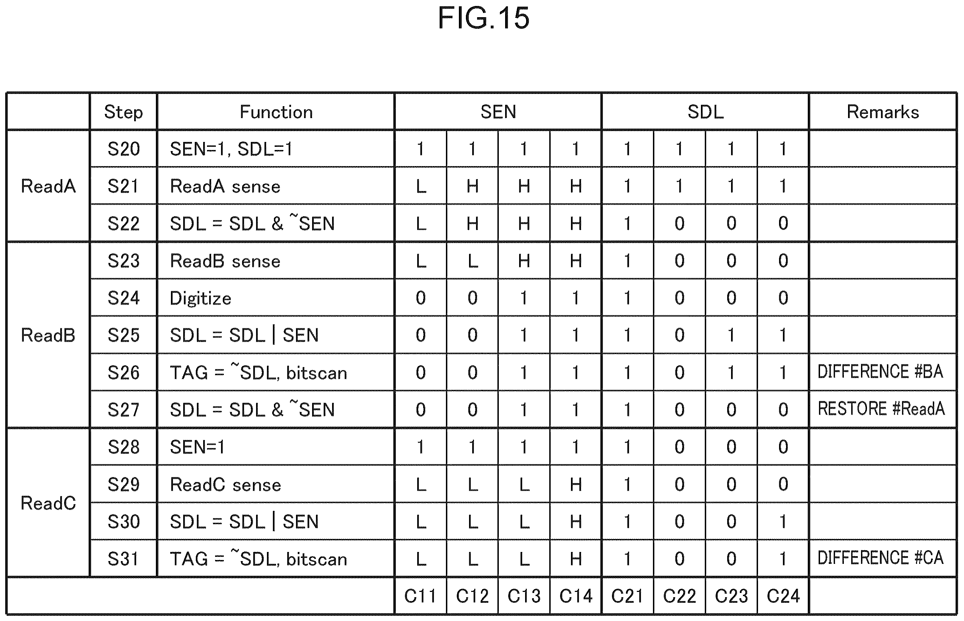

FIG. 14A is a flowchart showing a procedure of the process performed by the sequencer 25 in the adjustment read operation. FIG. 14B shows an example of voltage variation in each piece of wiring at the time when the adjustment read operation including the tracking process and the read process is performed. More specifically, FIG. 14B shows an example of voltage variation in each piece of wiring in sensing by using the read voltage R15 - VCG (Step S21 shown in FIG. 14A), sensing by using the read voltage R15 (Step S23 shown in FIG. 14A), and sensing by using the read voltage R15 + VCG (Step S29 shown in FIG. 14A) as the tracking process, and the read process that is performed after the tracking process (Step S34 shown in FIG. 14A). FIG. 15 shows transition of a voltage level at the node SEN when the process shown in FIG. 14A is performed, and transition of data held by the node LAT_S of the latch circuit SDL.

In the transition of a voltage level at the node SEN shown in FIG. 15, "L" and "H" each indicate a voltage level corresponding to analog data, and "0" and "1" each indicate a voltage level corresponding to digital data. That is, the voltage level "0" at the node SEN in FIG. 15 means that the node SEN has a voltage level corresponding to digital data of "0", in other words, digital data of "0" is held by the node SEN. The voltage level "1" at the node SEN means that the node SEN has a voltage level corresponding to digital data of "1", in other words, digital data of "1" is held by the node SEN.

A C11 column and a C21 column shown in FIG. 15 respectively indicate transition of a voltage level at the node SEN and transition of data held by the latch circuit SDL when the threshold voltage Vth of the memory cell transistor MT satisfies "Vth ≤ Rm_def - VCG". A C12 column and a C22 column respectively indicate transition of a voltage level at the node SEN and transition of data held by the latch circuit SDL when the threshold voltage Vth of the memory cell transistor MT satisfies "Rm_def - VCG < Vth ≤ Rm_def". A C13 column and a C23 column respectively indicate transition of a voltage level at the node SEN and transition of data held by the latch circuit SDL when the threshold voltage Vth of the memory cell transistor MT satisfies "Rm_def < Vth ≤ Rm_def + VCG". A C14 column and a C24 column respectively indicate transition of a voltage level at the node SEN and transition of data held by the latch circuit SDL when the threshold voltage Vth of the memory cell transistor MT satisfies "Rm_def + VCG < Vth".

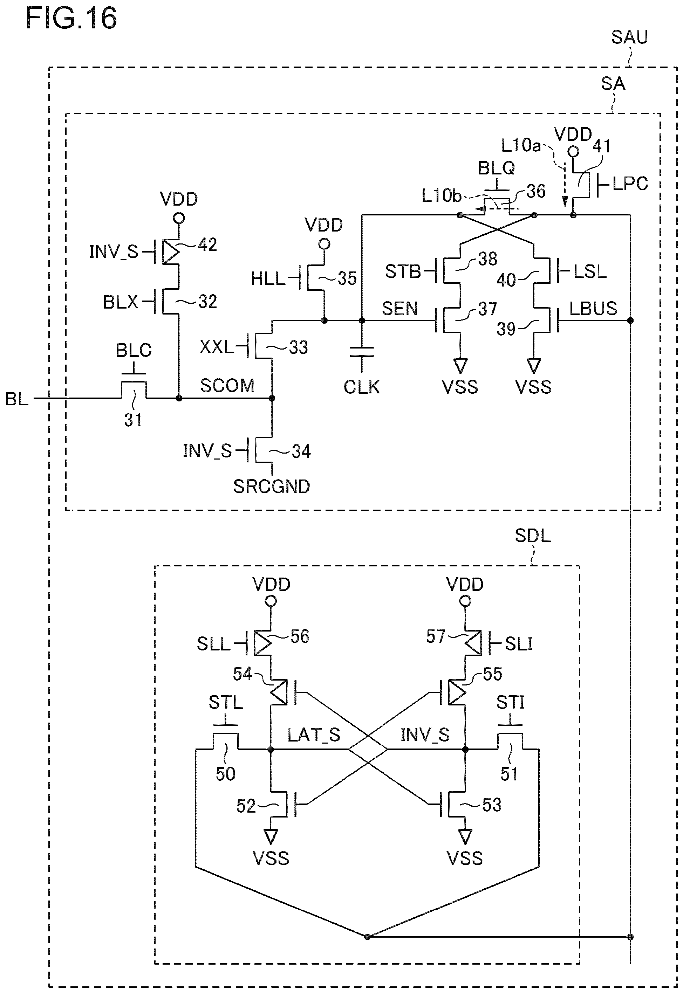

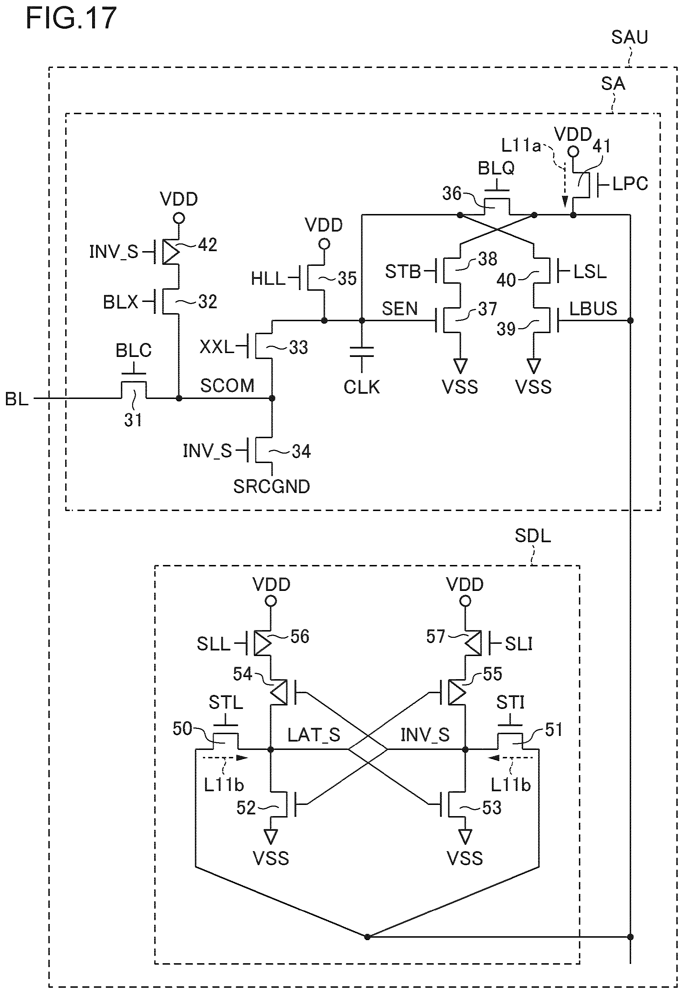

As shown in FIG. 14A, first, the sequencer 25 performs a process of resetting the node SEN of the sense amplification part SA and the latch circuit SDL for each of the plurality of sense amplifier units SAU (Step S20). Specifically, the sequencer 25 sets the signal LPC and the signal BLQ shown in FIG. 16 to the "H" level. Due to this, the transistors 41 and 36 are turned on, so that current paths as indicated by dashed lines L10a and L10b in FIG. 16 are formed, and the power supply voltage VDD is supplied to the node SEN. The sequencer 25 also sets the signal LPC and the signal STL shown in FIG. 17 to the "H" level. Due to this, the transistors 41 and 50 are turned on, so that current paths indicated by dashed lines L11a and L11b in FIG. 17 are formed, and the power supply voltage VDD is supplied to the node LAT_S of the latch circuit SDL. As a result, as shown in Step S20 in FIG. 15, the voltage at the node SEN is set to a voltage corresponding to a digital value "1", and data of "1" is held by the latch circuit SDL.

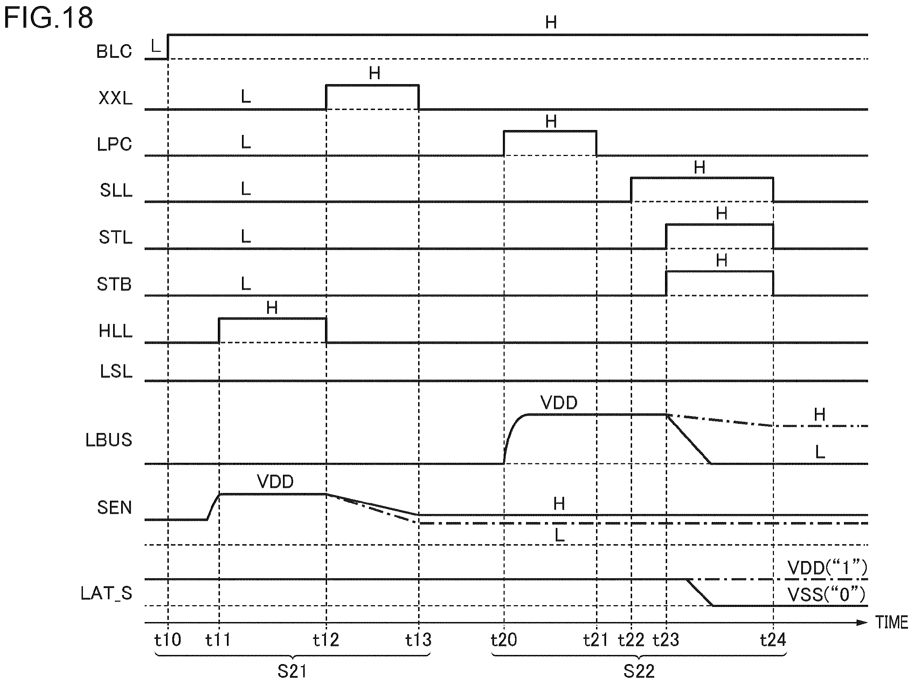

Subsequently, as shown in FIG. 14A, the sequencer 25 senses the voltage of the corresponding bit line BL by the sense amplification part SA using the read voltage "Rm_def - VCG" as the first sense parameter (Step S21), and holds data corresponding to the sensed voltage in the latch circuit SDL (Step S22). FIG. 18 shows transition of the signals BLC, XXL, LPC, STB, HLL, and LSL of the sense amplification part SA, transition of the signals SLL and STL of the latch circuit SDL, transition of the voltage level of the bus LBUS, transition of the voltage level at the node SEN, and transition of the voltage level at the node LAT_S of the latch circuit SDL at Steps S21 and S22.

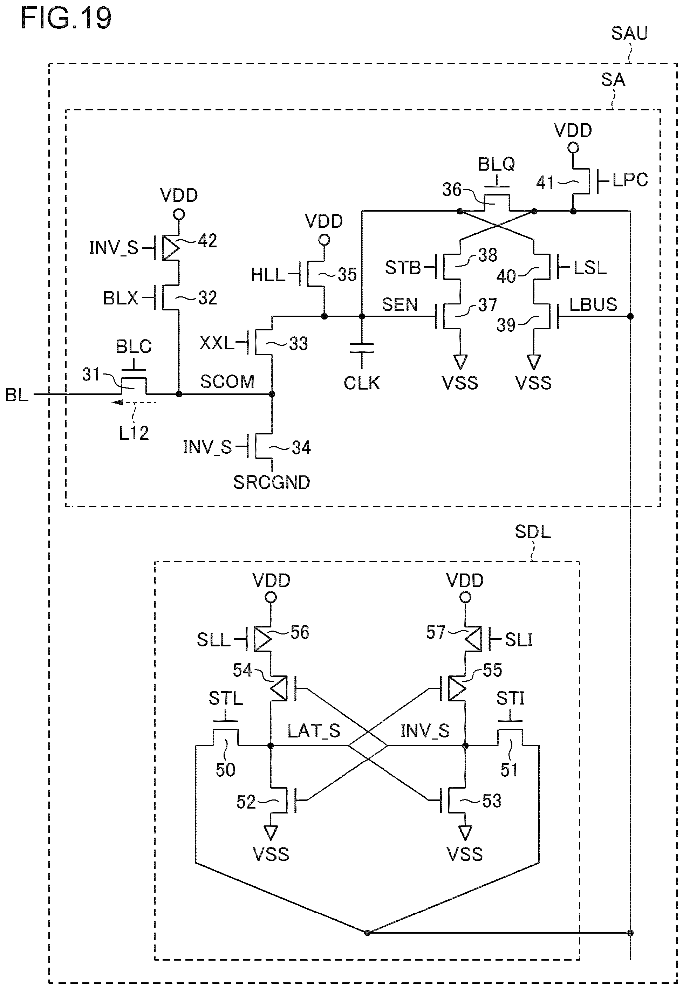

As shown in FIG. 18, first, the sequencer 25 sets the signal BLC to the "H" level at time t10. Due to this, as shown in FIG. 19, the transistor 31 is turned on in the sense amplification part SA, so that a current path as indicated by a dashed line L12 in FIG. 19 is formed, and the node SCOM is connected to the bit line BL.

The sequencer 25 applies the read voltage "Rm_def - VCG" to the word line WL (selected word line WLsel) connected to the memory cell transistor MT as a target of the read process at the time t10. At this point, the sequencer 25 applies, for example, 5 V to a drain-side select gate line SGDsel corresponding to a selected string unit SU, a drain-side select gate line SGDusel corresponding to a non-selected string unit SU, and a source-side select gate line SGS to turn on the selection transistor ST1 and the selection transistor ST2 included in a selected block BLK. Additionally, by applying the read pass voltage VREAD to the word line WL (non-selected word line WLusel) connected to the memory cell transistor MT that is not a read target, the memory cell transistor MT connected to a non-selected word line WLusel is turned on.

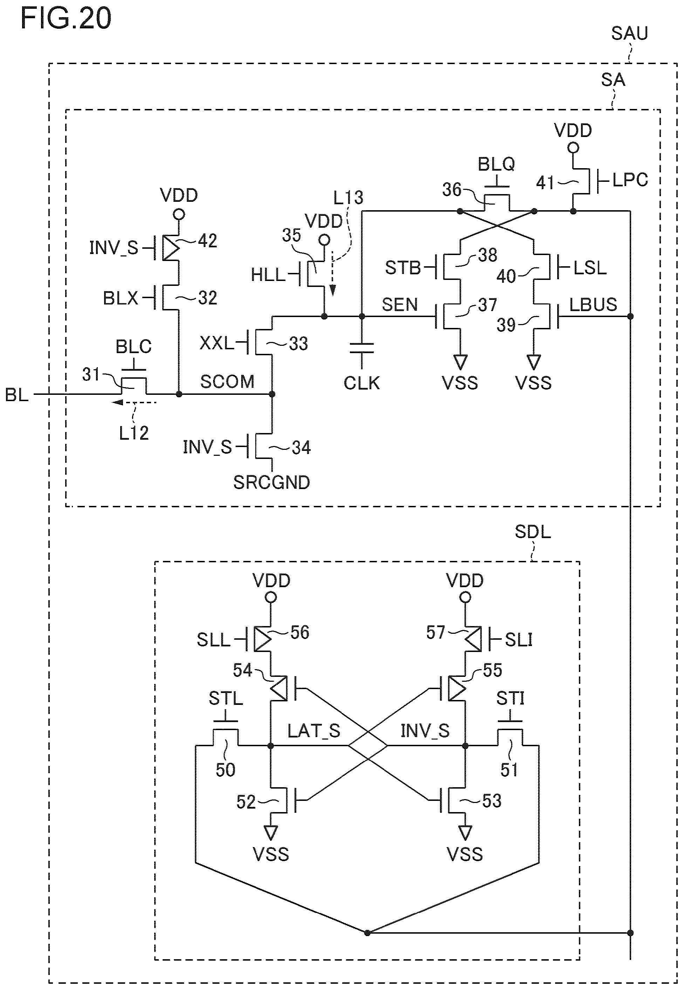

Subsequently, as shown in FIG. 18, the sequencer 25 sets the signal HLL to the "H" level at time t11. Due to this, the transistor 35 is turned on in the sense amplification part SA shown in FIG. 20, so that a current path as indicated by a dashed line L13 in FIG. 20 is formed, and the power supply voltage VDD is applied to the node SEN. Due to this, as shown in FIG. 18, the node SEN is charged after the time t11.

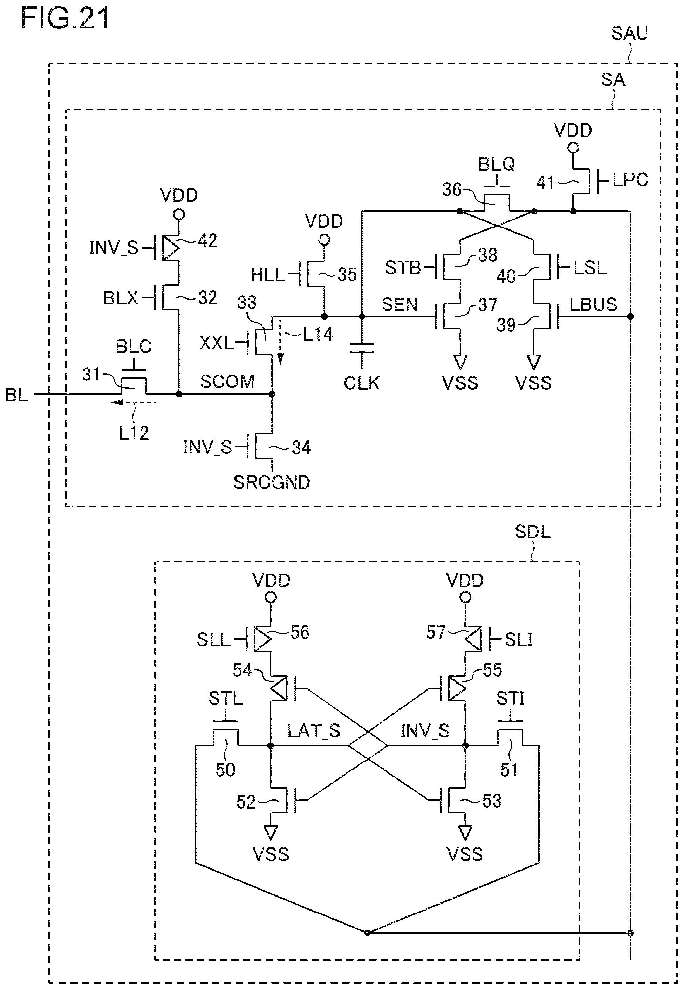

Thereafter, the sequencer 25 sets the signal HLL to the "L" level at time t12, and sets the signal XXL to the "H" level. Due to this, the transistor 35 shown in FIG. 21 is turned off and the transistor 33 is turned on, so that a current path as indicated by a dashed line L14 in FIG. 21 is formed, and the node SEN is connected to the bit line BL via the node SCOM. At this point, when the threshold voltage Vth of the memory cell transistor MT as a read target is equal to or lower than the read voltage "Rm_def - VCG", the memory cell transistor MT as a read target is turned on, so that a current conducts through all NAND strings NS included in the selected block BLK. Due to this, the node SEN conducts to a source line SL via the bit line BL and the NAND string NS, so that the node SEN is discharged. Due to this, the voltage level at the node SEN becomes the "L" level after the time t12 as indicated by a dot-and-dash line in FIG. 18. On the other hand, when the threshold voltage Vth of the memory cell transistor MT as a read target is higher than the read voltage "Rm_def - VCG", the memory cell transistor MT as a read target is turned off, so that the voltage level at the node SEN is maintained at the "H" level after the time t12 as indicated by a solid line in FIG. 18.

Subsequently, the sequencer 25 sets the signal XXL to the "L" level at time t13. Due to this, the voltage level at the node SEN is maintained at the "L" level or the "H" level after the time t13. The process from the time t10 to the time t13 is an example of a process performed at Step S21 shown in FIG. 14A. At the time t13, that is, at the time when the process at Step S21 shown in FIG. 14A is performed, the voltage at the node SEN and the data held by the latch circuit SDL reach a state shown at Step S21 in FIG. 15 in accordance with the threshold voltage Vth of the memory cell transistor MT.

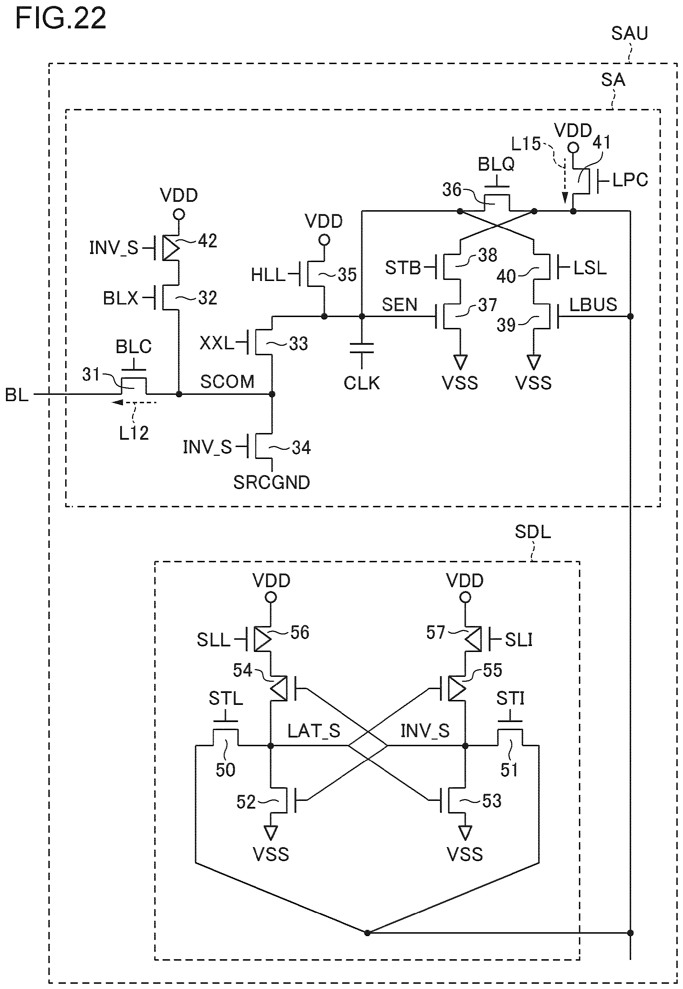

Subsequently, as shown in FIG. 18, the sequencer 25 sets the signal LPC to the "H" level at time t20. Due to this, as shown in FIG. 22, the transistor 41 is turned on in the sense amplification part SA, so that a current path as indicated by a dashed line L15 in FIG. 22 is formed, and the power supply voltage VDD is applied to the bus LBUS. Thereafter, as shown in FIG. 18, the sequencer 25 sets the signal LPC to the "L" level at time t21. Due to this, the transistor 41 is turned off in the sense amplification part SA.

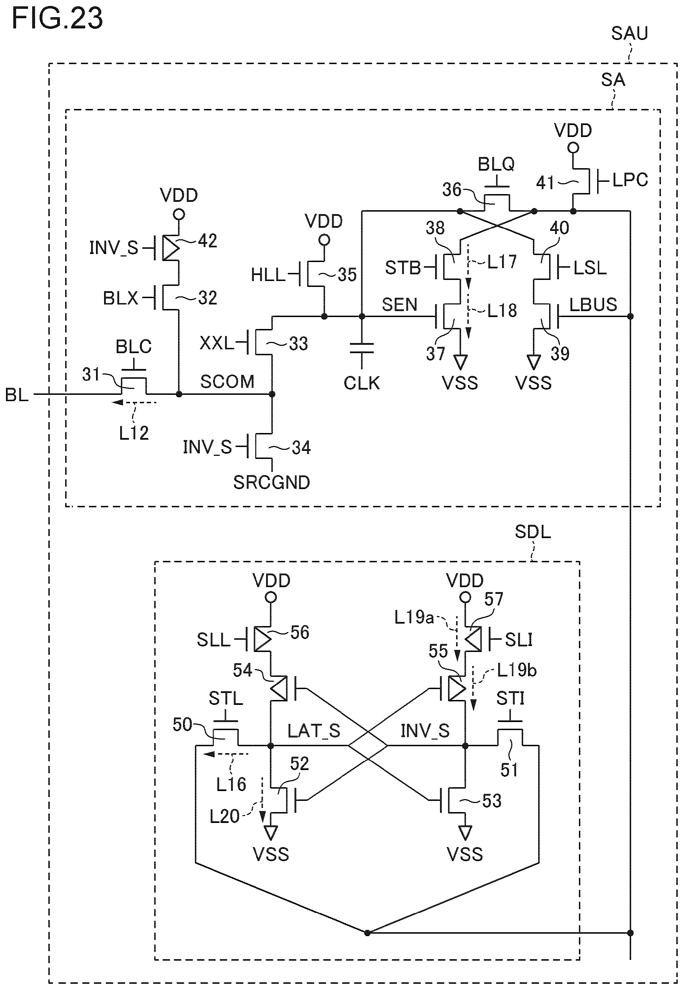

As shown in FIG. 18, the sequencer 25 sets the signal SLL to the "H" level at time t22. Due to this, as shown in FIG. 23, the transistor 56 is turned off in the latch circuit SDL. At this point, the sequencer 25 maintains the signals STI and SLI at the "L" level, so that the transistor 51 is maintained in an off state and the transistor 57 is maintained in an on state. Due to this, a current path as indicated by a dashed line L19a in FIG. 23 is formed in the latch circuit SDL.

Subsequently, as shown in FIG. 18, the sequencer 25 sets the signal STL to the "H" level at time t23. Due to this, as shown in FIG. 23, the transistor 50 is turned on in the latch circuit SDL, so that a current path as indicated by a dashed line L16 in FIG. 23 is formed. Accordingly, the node LAT_S of the latch circuit SDL is connected to the bus LBUS.

As shown in FIG. 18, the sequencer 25 sets the signal STB to the "H" level at the time t23. Due to this, as shown in FIG. 23, the transistor 38 is turned on in the sense amplification part SA, so that a current path as indicated by a dashed line L17 is formed.

At this point, when the voltage level at the node SEN is the "H" level, the transistor 37 is turned on corresponding to the voltage level at the node SEN, so that a current path as indicated by a dashed line L18 is further formed. Due to this, the ground voltage VSS is applied to the bus LBUS, so that the voltage of the bus LBUS is lowered to the "L" level after the time t23 as indicated by a solid line in FIG. 18. The ground voltage VSS is also applied to the node LAT_S of the latch circuit SDL via the current path as indicated by the dashed line L16 in FIG. 23, so that the voltage at the node LAT_S is also lowered to the ground voltage VSS after the time t23 as indicated by a solid line in FIG. 18. At this point, as shown in FIG. 23, the voltage at the node LAT_S becomes the ground voltage VSS in the latch circuit SDL, and the transistor 53 is turned off and the transistor 55 is turned on, so that a current path as indicated by a dashed line L19b in FIG. 23 is formed, the power supply voltage VDD is applied to the node INV_S via the transistor 55 and the transistor 57, and this state is maintained. When the power supply voltage VDD is applied to the node INV_S, the transistor 52 is turned on and the transistor 54 is turned off, so that a current path as indicated by a dashed line L20 in FIG. 23 is further formed. Due to this, the ground voltage VSS is applied to the node LAT_S, and this state is maintained.

As shown in FIG. 18, when the sequencer 25 sets the signal STB to the "L" level at time t24, the transistor 38 is turned off in the sense amplification part SA. When the sequencer 25 sets the signals SLL and STL to the "L" level at the time t24, the transistor 56 is turned on and the transistor 50 is turned off in the latch circuit SDL. That is, the node LAT_S is not connected to the bus LBUS. Even in such a state, in the latch circuit SDL, application of the ground voltage VSS to the node LAT_S is continued, and application of the power supply voltage VDD to the node INV_S is continued. Thus, the node LAT_S is maintained at the ground voltage VSS, and the node INV_S is maintained at the power supply voltage VDD in the latch circuit SDL. As a result, data of "0" is held by the node LAT_S, and data of "1" is held by the node INV_S.

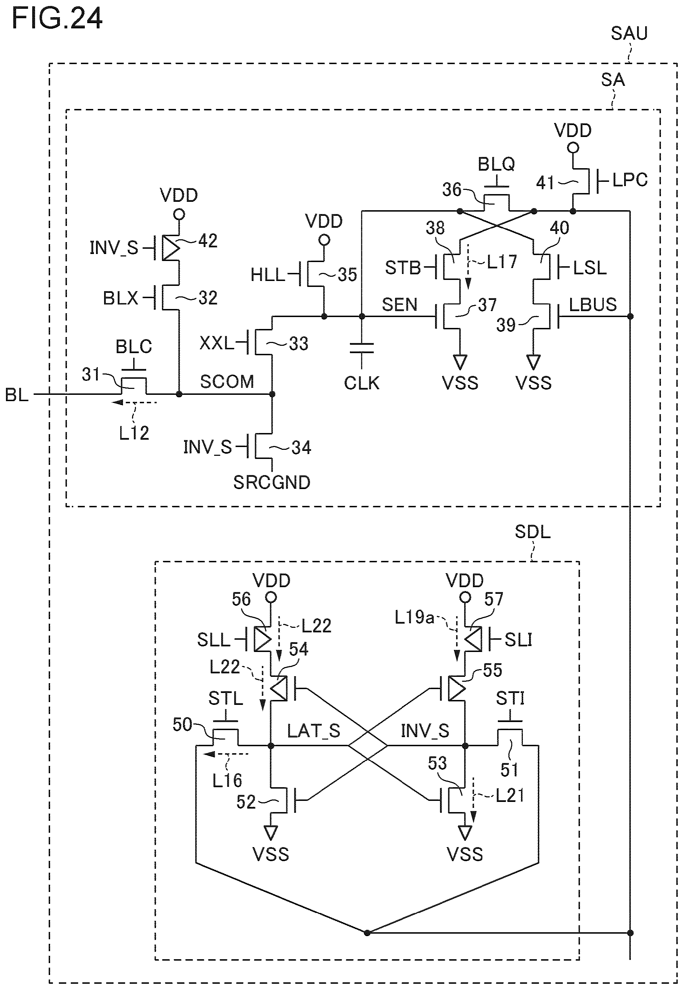

On the other hand, when the voltage level at the node SEN is the "L" level, the transistor 37 is turned on corresponding to the voltage level at the node SEN, so that the current path as indicated by the dashed line L18 in FIG. 23 is formed, but the voltage of the bus LBUS is more easily maintained at the "H" level as compared with a case in which the voltage level at the node SEN is the "H" level. Accordingly, the node LAT_S of the latch circuit SDL is more easily maintained at the "H" level. Due to this, as shown in FIG. 24, the transistor 53 is turned on and the transistor 55 is turned off in the latch circuit SDL, so that a current path as indicated by a dashed line L21 in FIG. 24 is formed, the ground voltage VSS is applied to the node INV_S via the transistor 53, and this state is maintained. When the ground voltage VSS is applied to the node INV_S, the transistor 52 is turned off and the transistor 54 is turned on. In this state, as shown in FIG. 18, when the sequencer 25 sets the signals STB, SLL, and STL to the "L" level at the time t24, the transistors 38 and 50 are turned off while the transistor 56 is turned on. As a result, a current path as indicated by a dashed line L22 in FIG. 24 is further formed, so that the power supply voltage VDD is applied to the node LAT_S via the transistor 54 and the transistor 56, and this state is maintained. As a result, data of "1" is held by the node LAT_S, and data of "0" is held by the node INV_S.

The process from the time t20 to the time t24 shown in FIG. 18 is an example of the process performed at Step S22 shown in FIG. 14A. At the time t24, that is, at the time when the process at Step S22 shown in FIG. 14A is performed, the voltage at the node SEN and the data held by the latch circuit SDL reach a state shown at Step S22 in FIG. 15 in accordance with the threshold voltage Vth of the memory cell transistor MT. As shown in FIG. 15, the process at Step S22 corresponds to a process of inverting the voltage at the node SEN, computing a logical product of the inverted voltage and the data held by the latch circuit SDL (AND operation), and storing a computation result thereof in the latch circuit SDL, that is, a process of computing "SDL = SDL&^{~}SEN". Hereinafter, the data held by the latch circuit SDL at the time when the process at Step S22 is completed, in other words, data read from the memory cell transistor MT when the read voltage "Rm_def - VCG" is used, is also referred to as first read data #ReadA.

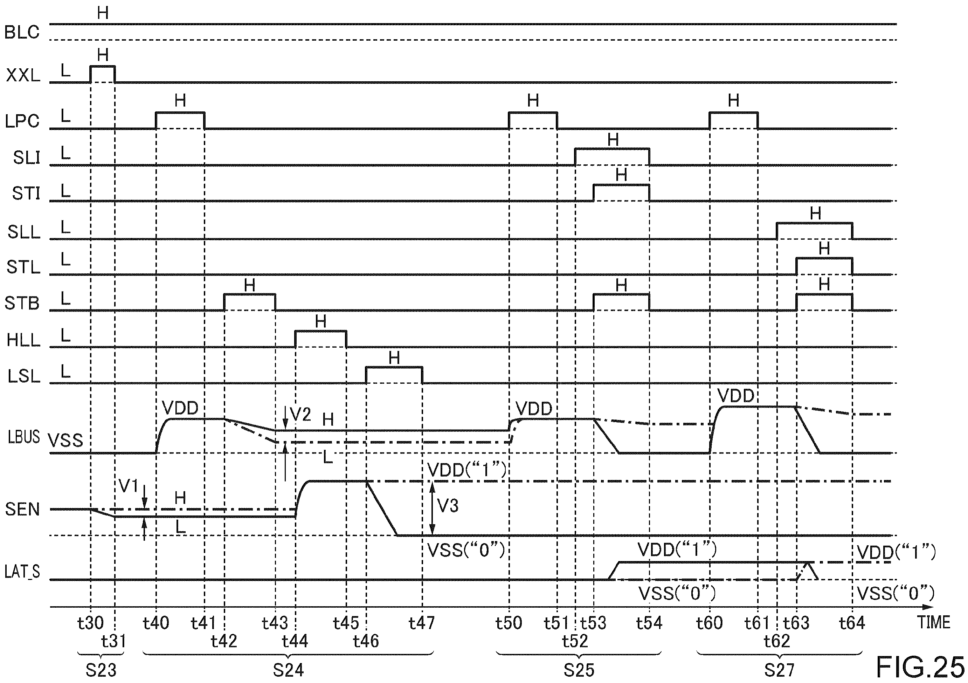

As shown in FIG. 14A, following Step S22, the sequencer 25 senses the voltage of the corresponding bit line BL by the sense amplification part SA using the read voltage Rm_def as the second sense parameter (Step S23). FIG. 25 shows transition of the signals BLC, XXL, LPC, STB, HLL, and LSL of the sense amplification part SA, transition of the signals SLL and STL of the latch circuit SDL, transition of the voltage level of the bus LBUS, transition of the voltage level at the node SEN, and transition of the voltage level at the node LAT_S of the latch circuit SDL at Steps S23 to S27.

As shown in FIG. 25, first, the sequencer 25 sets the signal XXL to the "H" level at time t30. Due to this, as shown in FIG. 21, the transistor 33 is turned on, so that the current path as indicated by the dashed line L14 in FIG. 21 is formed, and the node SEN is connected to the bit line BL via the node SCOM. At this point, when the threshold voltage Vth of the memory cell transistor MT as a read target is equal to or lower than the read voltage Rm, the memory cell transistor MT as a read target is turned on, so that the node SEN is discharged. Due to this, the voltage level at the node SEN becomes the "L" level after the time t30 as indicated by a solid line in FIG. 25. On the other hand, when the threshold voltage Vth of the memory cell transistor MT as a read target is higher than the read voltage Rm_def, the memory cell transistor MT as a read target is in the off state, so that the voltage level at the node SEN is maintained at the "H" level even after the time t12.

Subsequently, the sequencer 25 sets the signal XXL to the "L" level at time t31. Due to this, after the time t31, the voltage level at the node SEN is maintained at the "L" level or the "H" level. In FIG. 25, a difference between the "L" level and the "H" level at the node SEN is represented as V1. The process from the time t30 to the time t31 is an example of the process performed at Step S23 shown in FIG. 18. At the time t31, that is, at the time when the process at Step S23 shown in FIG. 14A is performed, the voltage at the node SEN and the data held by the latch circuit SDL reach a state shown at Step S23 in FIG. 15 in accordance with the threshold voltage Vth of the memory cell transistor MT.

As shown in FIG. 14A, following the process at Step S23, the sequencer 25 performs a process of converting the voltage at the node SEN into a voltage corresponding to digital data (Step S24). A process from time t40 to time t47 shown in FIG. 25 is an example of the process performed at Step S24 shown in FIG. 14A.

As shown in FIG. 25, first, the sequencer 25 sets the signal LPC to the "H" level at the time t40. Due to this, as shown in FIG. 22, the transistor 41 is turned on in the sense amplification part SA, so that the current path as indicated by the dashed line L15 in FIG. 22 is formed, and the power supply voltage VDD is applied to the bus LBUS. Thereafter, as shown in FIG. 25, the sequencer 25 sets the signal LPC to the "L" level at the time t41. Due to this, the transistor 41 is turned off in the sense amplification part SA.

Subsequently, the sequencer 25 sets the signal STB to the "H" level at the time t42. Due to this, as shown in FIG. 23, the transistor 38 is turned on in the sense amplification part SA, so that the current path as indicated by the dashed line L17 is formed. At this point, when the voltage level at the node SEN is the "H" level, the transistor 37 is turned on corresponding to the voltage level at the node SEN, so that the current path as indicated by the dashed line L18 is further formed. Due to this, the ground voltage VSS is applied to the bus LBUS, so that the voltage of the bus LBUS is lowered to the "L" level after the time t42 as indicated by a dot-and-dash line in FIG. 25.

On the other hand, when the voltage level at the node SEN is the "L" level, the transistor 37 is turned on corresponding to the voltage level at the node SEN, so that the current path as indicated by the dashed line L18 in FIG. 23 is formed, but the voltage of the bus LBUS is more easily maintained at the "H" level as compared with a case in which the voltage level at the node SEN is the "H" level as indicated by a solid line in FIG. 25.

Subsequently, when the sequencer 25 sets the signal STB to the "L" level at the time t43, the voltage of the bus LBUS is maintained thereafter. That is, when the voltage level at the node SEN is the "L" level as indicated by a solid line in FIG. 25, the voltage of the bus LBUS is maintained at the "H" level as similarly indicated by a solid line. When the voltage level at the node SEN is the "H" level as indicated by a dot-and-dash line in FIG. 25, the voltage of the bus LBUS is maintained at the "L" level as similarly indicated by a dot-and-dash line. In FIG. 25, a difference between the "H" level and the "L" level of the bus LBUS is represented as V2.

Subsequently, when the sequencer 25 sets the signal HLL to the "L" level at the time t44, as shown in FIG. 20, the transistor 35 is turned on in the sense amplification part SA. Due to this, the current path as indicated by the dashed line L13 in FIG. 20 is formed, and the power supply voltage VDD is applied to the node SEN. Thus, as shown in FIG. 25, after the time t44, the voltage at the node SEN becomes the power supply voltage VDD, that is, a voltage corresponding to data of "1".

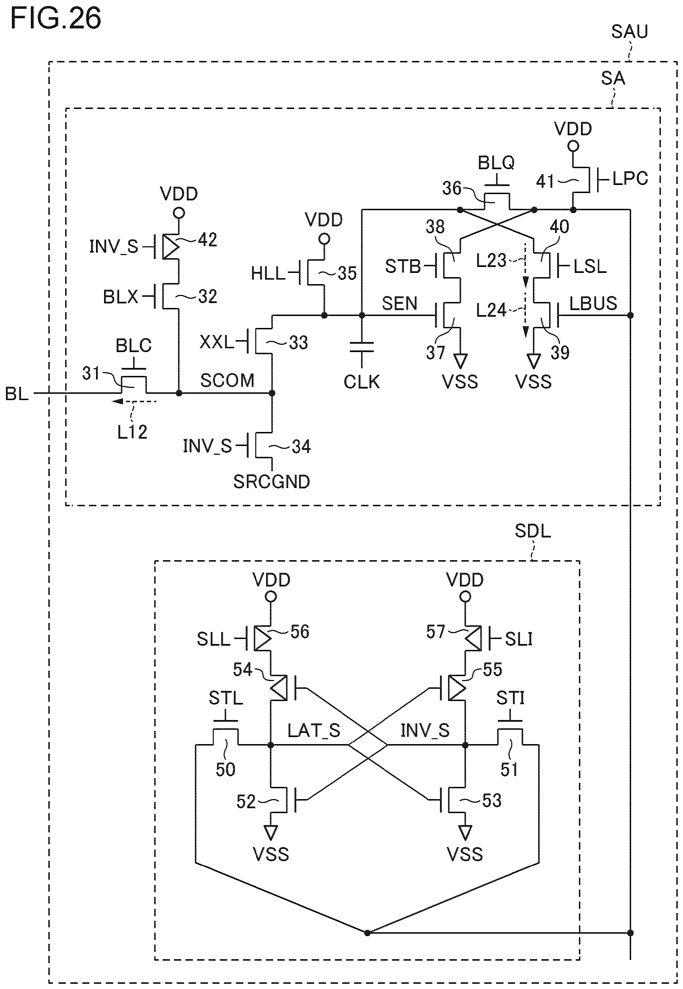

Thereafter, as shown in FIG. 25, when the sequencer 25 sets the signal HLL to the "L" level at the time t45, the transistor 35 is turned off in the sense amplification part SA. When the sequencer 25 sets the signal LSL to the "H" level at the time t46, the transistor 40 is turned on in the sense amplification part SA as shown in FIG. 26, so that a current path as indicated by a dashed line L23 is formed in the sense amplification part SA.

At this point, when the voltage level of the bus LBUS is the "H" level, the transistor 39 is turned on, so that a current path as indicated by a dashed line L24 is further formed. Due to this, the ground voltage VSS is applied to the node SEN via the transistor 40 and the transistor 39, so that the voltage at the node SEN is lowered to the ground voltage VSS after the time t46 as indicated by a solid line in FIG. 25. When the sequencer 25 sets the signal LSL to the "L" level at the time t47, the transistor 40 is turned off in the sense amplification part SA. Due to this, the voltage at the node SEN is maintained at the ground voltage VSS after the time t47.

On the other hand, when the voltage level of the bus LBUS is the "L" level, the transistor 39 is turned off, so that the current path as indicated by the dashed line L24 in FIG. 26 is not formed. As a result, the voltage at the node SEN is maintained at the power supply voltage VDD even after the time t47 as indicated by a dot-and-dash line in FIG. 25.

Due to the process from the time t40 to the time t47 described above, when the voltage at the node SEN is at the "H" level at the time t40, the voltage at the node SEN is converted into the power supply voltage VDD, in other words, a voltage corresponding to digital data of "1", at the time t46. When the voltage at the node SEN is at the "L" level at the time t40, the voltage at the node SEN is converted into the ground voltage VSS, in other words, a voltage corresponding to digital data of "0", at the time t46. As a result, digital data corresponding to the read voltage Rm_def is held by the node SEN. In FIG. 25, a difference between the voltage corresponding to the data of "1" at the node SEN and the voltage corresponding to the data of "0" at the time t46 is represented as V3.

At the time t47, that is, at the time when the process at Step S24 shown in FIG. 14A is performed, the voltage at the node SEN and the data held by the latch circuit SDL reach a state shown at Step S24 in FIG. 15 in accordance with the threshold voltage Vth of the memory cell transistor MT. Hereinafter, the data held by the latch circuit SDL at the time when the process at Step S24 is performed, in other words, data read from the memory cell transistor MT when the read voltage Rm_def is used, is also referred to as second read data #ReadB.

As shown in FIG. 14A, the sequencer 25 computes a difference between the data held by the latch circuit SDL and the data held by the node SEN following the process at Step S24 (Step S25). Considering that the first read data #ReadA is held by the latch circuit SDL and the second read data #ReadB is held by the node SEN at the time when Step S24 is performed, the process at Step S24 corresponds to a process of computing difference data #BA thereof (= #ReadB - #ReadA). A process from time t50 to time t54 shown in FIG. 25 is an example of the process performed at Step S25 shown in FIG. 14A.

As shown in FIG. 25, first, the sequencer 25 sets the signal LPC to the "H" level at time t50. Due to this, as shown in FIG. 22, the transistor 41 is turned on in the sense amplification part SA, so that the current path as indicated by the dashed line L15 in FIG. 22 is formed, and the power supply voltage VDD is applied to the bus LBUS. Thereafter, as shown in FIG. 25, the sequencer 25 sets the signal LPC to the "L" level at time t51. Due to this, the transistor 41 is turned off in the sense amplification part SA.

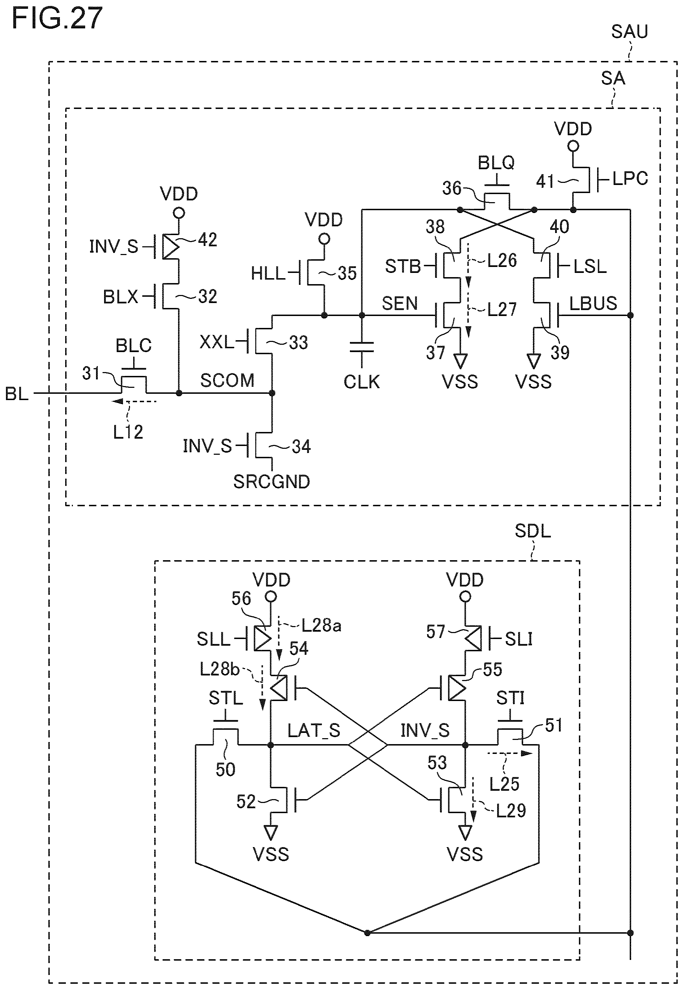

Subsequently, as shown in FIG. 25, the sequencer 25 sets the signal SLI to the "H" level at time t52. Due to this, as shown in FIG. 27, the transistor 57 is turned off in the latch circuit SDL. At this point, the sequencer 25 maintains the signals STL and SLL at the "L" level, so that the transistor 50 is maintained in the off state and the transistor 56 is maintained in the on state. Thus, a current path as indicated by a dashed line L28a in FIG. 27 is formed.

Subsequently, as shown in FIG. 25, the sequencer 25 sets the signal STI to the "H" level at time t53. Due to this, as shown in FIG. 27, the transistor 51 is turned on in the latch circuit SDL, so that a current path as indicated by a dashed line L25 in FIG. 27 is formed, and the node INV_S of the latch circuit SDL is connected to the bus LBUS. As shown in FIG. 25, the sequencer 25 sets the signal STB to the "H" level at the time t53. Due to this, as shown in FIG. 27, the transistor 38 is turned on in the sense amplification part SA, so that a current path as indicated by a dashed line L26 in FIG. 27 is formed.

At this point, when the voltage level at the node SEN is a voltage level corresponding to "1", that is, a voltage level corresponding to the power supply voltage VDD, the transistor 37 is in the on state, so that a current path as indicated by a dashed line L27 is further formed. Due to this, the ground voltage VSS is applied to the bus LBUS, so that the voltage of the bus LBUS is lowered to the ground voltage VSS after the time t53 as indicated by a solid line in FIG. 25. The ground voltage VSS is also applied to the node INV_S of the latch circuit SDL via the current path indicated by the dashed line L25 in FIG. 27, so that the voltage at the node INV_S is also lowered to the ground voltage VSS after the time t53. At this point, as shown in FIG. 27, in the latch circuit SDL, the transistor 52 is turned off and the transistor 54 is turned on as the voltage at the node INV_S becomes the ground voltage VSS, so that a current path as indicated by a dashed line L28b in FIG. 27 is formed, and the power supply voltage VDD is applied to the node LAT_S via the transistor 56 and the transistor 54. Thus, as indicated by a solid line in FIG. 25, the voltage at the node LAT_S is increased to the power supply voltage VDD after the time t53, and this state is maintained. As shown in FIG. 27, the transistor 53 is turned on and the transistor 55 is turned off as the power supply voltage VDD is applied to the node LAT_S, so that a current path as indicated by a dashed line L29 in FIG. 27 is formed. Due to this, the ground voltage VSS is applied to the node INV_S, and this state is maintained.

As shown in FIG. 25, when the sequencer 25 sets the signal STB to the "L" level at time t54, the transistor 38 is turned off in the sense amplification part SA. When the sequencer 25 sets the signals SLI and STI to the "L" level at the time t54, the transistor 51 is turned off and the transistor 57 is turned on in the latch circuit SDL. That is, the node INV_S is not connected to the bus LBUS. Even in such a state, in the latch circuit SDL, application of the ground voltage VSS to the node INV_S is continued, and application of the power supply voltage VDD to the node LAT_S is continued. Thus, in the latch circuit SDL, the node INV_S is maintained at the ground voltage VSS, and the node LAT_S is maintained at the power supply voltage VDD. As a result, data of "1" is held by the node LAT_S, and data of "0" is held by the node INV_S.

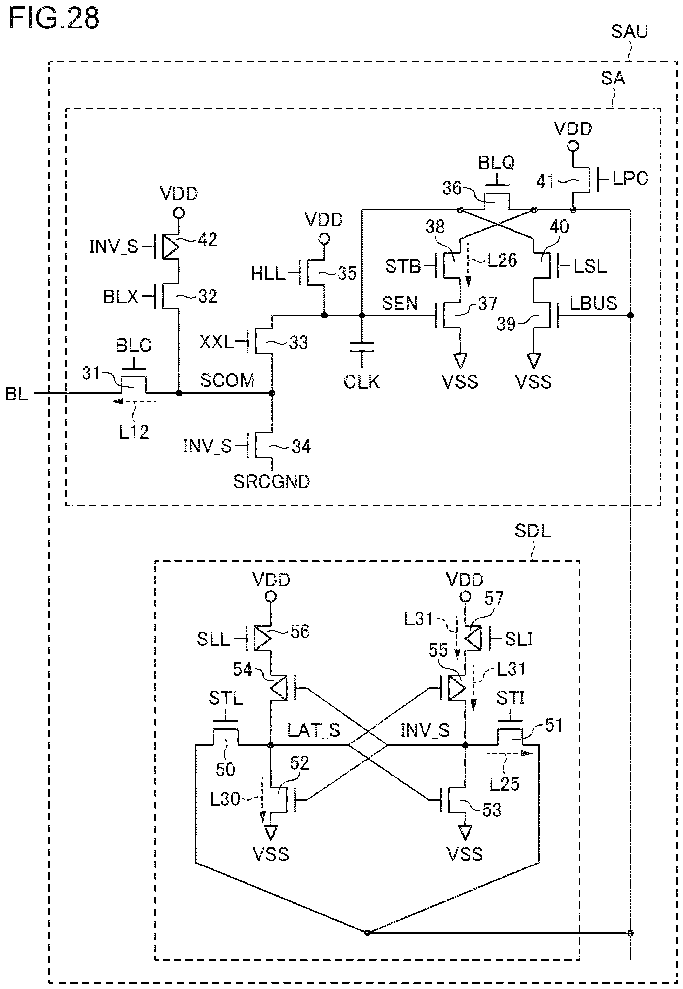

On the other hand, when the voltage level at the node SEN is a voltage level corresponding to "0", the transistor 37 is in the off state, so that the current path as indicated by the dashed line L27 in FIG. 27 is not formed. Due to this, the voltage of the bus LBUS is maintained at the "H" level, so that the node INV_S of the latch circuit SDL is maintained at the "H" level. Thus, as shown in FIG. 28, the transistor 52 is turned on and the transistor 54 is turned off in the latch circuit SDL, so that a current path as indicated by a dashed line L30 in FIG. 28 is formed, the ground voltage VSS is applied to the node LAT_S via the transistor 52, and this state is maintained. When the ground voltage VSS is applied to the node LAT_S, the transistor 53 is turned off and the transistor 55 is turned on. In this state, as shown in FIG. 25, the sequencer 25 sets the signals STB, SLI, and STI to the "L" level at the time t54, the transistors 38 and 51 are turned off while the transistor 57 is turned on. As a result, a current path as indicated by a dashed line L31 in FIG. 28 is formed, so that the power supply voltage VDD is applied to the node INV_S via the transistor 55 and the transistor 57, and this state is maintained. Due to this, data of "0" is held by the node LAT_S and data of "1" is held by the node INV_S.

The process from the time t50 to the time t54 shown in FIG. 25 is an example of the process performed at Step S25 shown in FIG. 14A. At the time t54, that is, at the time when the process at Step S25 shown in FIG. 14A is performed, the voltage at the node SEN and the data held by the latch circuit SDL reach a state shown at Step S25 in FIG. 15 in accordance with the threshold voltage Vth of the memory cell transistor MT. As shown in FIG. 15, the process at Step S25 corresponds to a process of computing a logical sum of the voltage at the node SEN and the data held by the latch circuit SDL (OR operation), and storing a computation result thereof in the latch circuit SDL, that is, a process of computing "SDL = SDL | SEN". As a result, difference data #BA between the first read data #ReadA held by the latch circuit SDL and the second read data #ReadB held by the node SEN is held by the latch circuit SDL. In the process at Step S25, as shown in FIG. 15, data of "0" is held by the latch circuit SDL only when the threshold voltage Vth of the memory cell transistor MT as a read target satisfies "Rm_def - VCG < Vth ≤ Rm_def".

As shown in FIG. 14A, the sequencer 25 calculates the on-cell count N_BA by a bit scan process following the process at Step S25 (Step S26). Specifically, the sequencer 25 counts the number of the sense amplifier units SAU in which data of "0" is held by the node LAT_S of the latch circuit SDL, in other words, the number of the sense amplifier units SAU in which the difference data #BA indicates "0", in the plurality of sense amplifier units SAU by using the bit scan circuit 29 shown in FIG. 2. Actually, the bit scan circuit 29 counts "^{~}SDL = 1", that is, the number of the sense amplifier units SAU in which data of "1" is held by the node INV_S of the latch circuit SDL, by detecting bit data (^{~}SDL) obtained by inverting bit data held by the latch circuit SDL. Due to this, the bit scan circuit 29 can count the number of the memory cell transistors MT in which the threshold voltage Vth of the memory cell transistor MT satisfies "Rm_def - VCG < Vth ≤ Rm_def", in other words, the on-cell count N_BA shown in FIG. 10. Through the process at Step S26, the sequencer 25 acquires the on-cell count N_BA.

Subsequently, as shown in FIG. 14A, the sequencer 25 restores the first read data #ReadA to the latch circuit SDL (Step S27). Specifically, at the time when the process at Step S26 is performed, the difference data #BA is held by the latch circuit SDL and the second read data #ReadB is held by the node SEN, so that the first read data #ReadA can be restored to the latch circuit SDL by computing a difference therebetween. That is, as shown in FIG. 15, the same process as the process at Step S22, that is, the process of computing "SDL = SDL&^{~}SEN", may be performed in the process at Step S27. A process from time t60 to time t64 shown in FIG. 25 is an example of the process performed at Step S27 shown in FIG. 14A. This process is the same as the process from the time t20 to the time t24 shown in FIG. 18, so that detailed description thereof will not be repeated. When the process at Step S27 is performed, the voltage at the node SEN and the data held by the latch circuit SDL reach a state shown at Step S27 in FIG. 15. That is, the first read data #ReadA is restored to the latch circuit SDL.

Subsequently, as shown in FIG. 14A, the sequencer 25 resets the node SEN of the sense amplification part SA (Step S28). Specifically, as shown in FIG. 16, the sequencer 25 sets the signal LPC and the signal BLQ to the "H" level. Due to this, the transistors 41 and 36 are turned on, so that the current paths as indicated by the dashed lines L10a and L10b in FIG. 16 are formed, and the power supply voltage VDD is supplied to the node SEN. Thus, as shown at Step S28 in FIG. 15, the voltage at the node SEN is set to a voltage corresponding to a digital value "1".

Thereafter, as shown in FIG. 14A, the sequencer 25 senses the voltage of the corresponding bit line BL by the sense amplification part SA using the read voltage "Rm_def + VCG" as the third sense parameter (Step S29). The process at Step S29 is the same as the process at Step S21 except a difference in the read voltage, so that detailed description thereof will not be repeated.

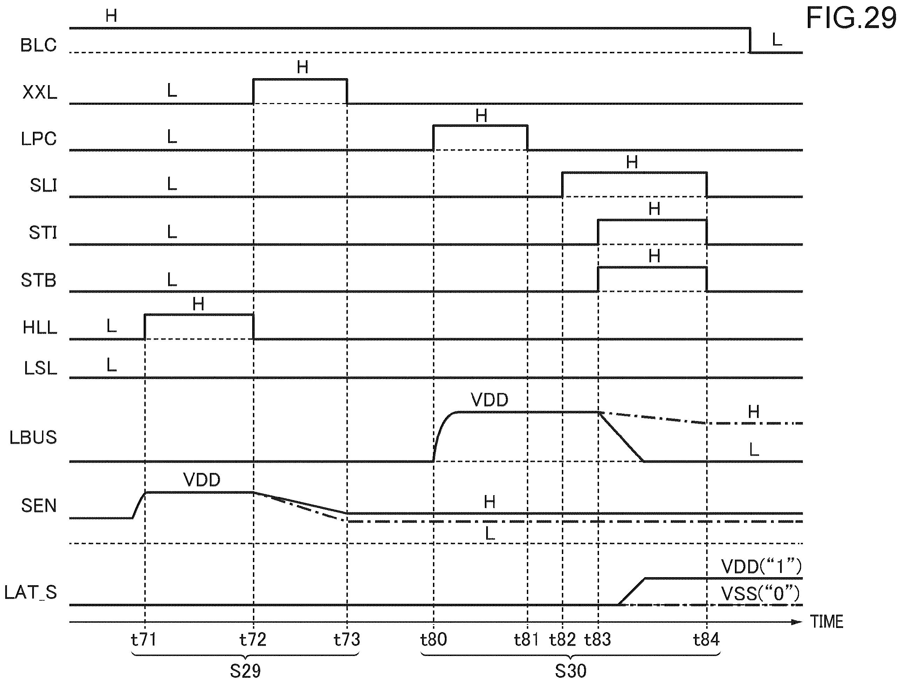

FIG. 29 shows transition of the signals BLC, XXL, LPC, STB, HLL, and LSL of the sense amplification part SA, transition of the signals SLL and STL of the latch circuit SDL, transition of the voltage level of the bus LBUS, transition of the voltage level at the node SEN, and transition of the voltage level at the node LAT_S of the latch circuit SDL at Steps S28 to S31. As shown in FIG. 29, as a process from time t71 to time t73, the sequencer 25 performs the same process as the process from the time t11 to the time t13 shown in FIG. 18. When the process at Step S29 in FIG. 14A is performed, the voltage at the node SEN and the data held by the latch circuit SDL reach a state shown at Step S29 in FIG. 15.

Subsequently, as shown in FIG. 14A, the sequencer 25 computes a difference between the data held by the latch circuit SDL and the data held by the node SEN (Step S30). At the time when the process at Step S29 is performed, the first read data #ReadA is held by the latch circuit SDL. The node SEN holds a voltage corresponding to data read from the memory cell transistor MT when the read voltage "Rm_def + VCG" is used. Hereinafter, the data read from the memory cell transistor MT when the read voltage "Rm_def + VCG" is used is also referred to as third read data #ReadC. The process at Step S30 corresponds to a process of computing difference data #CA thereof (= #ReadC - #ReadA). The process at Step S30 is the same as the process at Step S25, so that detailed description thereof will not be repeated. A process from time t80 to time t84 shown in FIG. 29 is an example of the process performed at Step S30 shown in FIG. 14A. As shown in FIG. 29, as the process from the time t80 to the time t84, the sequencer 25 performs the same process as the process from the time t50 to the time t54 shown in FIG. 25. When the process at Step S30 shown in FIG. 14A is performed, the voltage at the node SEN and the data held by the latch circuit SDL reach a state shown at Step S30 in FIG. 15.

Subsequently, as shown in FIG. 14A, the sequencer 25 computes the on-cell count N_CA by the bit scan process (Step S31). Specifically, the sequencer 25 counts the number of the sense amplifier units SAU in which data of "0" is held by the node LAT_S of the latch circuit SDL, in other words, the number of the sense amplifier units SAU in which the difference data #CA indicates "0", in the plurality of sense amplifier units SAU by using the bit scan circuit 29 shown in FIG. 2. Actually, the bit scan circuit 29 counts "^{~}SDL = 1", that is, the number of the sense amplifier units SAU in which data of "1" is held by the node INV_S of the latch circuit SDL, by detecting bit data (^{~}SDL) obtained by inverting bit data held by the latch circuit SDL. Due to this, the bit scan circuit 29 can count the number of the memory cell transistors MT in which the threshold voltage Vth of the memory cell transistor MT satisfies "Rm_def - VCG < Vth ≤ Rm_def + VCG", in other words, the on-cell count N_CA (= N_BA + N_CB) shown in FIG. 10. Through the process at Step S31, the sequencer 25 acquires the on-cell count N_CA.

Subsequently, as shown in FIG. 14A, the sequencer 25 computes the on-cell count N_CB (Step S32). Specifically, the sequencer 25 computes a difference between the on-cell count N_CA obtained by the process at Step S31 and the on-cell count N_BA obtained by the process at Step S26 to obtain the on-cell count N_CB (= N_CA - N_BA).

Subsequently, as shown in FIG. 14A, the sequencer 25 determines the optimum read voltage Rm_opt using the on-cell count N_BA obtained by the process at Step S26 and the on-cell count N_CB obtained by the process at Step S32 (Step S33). The sequencer 25 performs, for example, the process shown in FIG. 12 as the process at Step S33 to determine the optimum read voltage Rm_opt from among the three read voltages Rm_def, Rm_def - VCG, and Rm_def + VCG.

Subsequently, as shown in FIG. 14A, the sequencer 25 performs the read process using the optimum read voltage Rm_opt determined by the process at Step S33 (Step S34).

### 1.8 Actions and effects of embodiment

As described above, the semiconductor storage device 2 according to the present embodiment includes the plurality of NAND strings NS including the plurality of memory cell transistors MT, the plurality of bit lines BL respectively connected to the plurality of NAND strings NS, the plurality of sense amplifier units SAU respectively connected to the plurality of bit lines BL, and the sequencer 25 (control circuit) configured to perform the adjustment read operation. The sense amplifier unit SAU includes the node SEN (sense node) connected to the memory cell transistor MT via the bit line BL, the sense amplification part SA configured to convert the voltage at the node SEN into data, and the latch circuit SDL configured to hold the data converted by the sense amplification part SA. The adjustment read operation includes the tracking process (first process) and the read process (second process).

By sensing the data held by the memory cell transistor MT using the read voltage "Rm_def - VCG" (first sense parameter) as the tracking process, the sequencer 25 supplies the first voltage corresponding to the first read data #ReadA to the node SEN via the bit line BL. The sequencer 25 also converts the first voltage at the node SEN into the first read data #ReadA by the sense amplification part SA to be held in the latch circuit SDL. Additionally, by sensing the data held by the memory cell transistor MT using the read voltage Rm_def (second sense parameter), the sequencer 25 supplies the second voltage corresponding to the second read data #ReadB to the node SEN via the bit line BL. The sequencer 25 then generates the first difference data #BA in the latch circuit SDL based on the first read data #ReadA held by the latch circuit SDL and the second voltage held by the node SEN. Furthermore, the sequencer 25 counts the on-cell count N_BA (first cell count) based on the first difference data #BA held by the latch circuit SDL in each of the plurality of sense amplifier units SAU.

The sequencer 25 also restores the first read data #ReadA to the latch circuit SDL. By sensing the data held by the memory cell transistor MT using the read voltage "Rm_def + VCG" (third sense parameter), the sequencer 25 supplies the third voltage corresponding to the third read data #ReadC to the node SEN via the bit line BL. The sequencer 25 also generates the second difference data #CA in the latch circuit SDL based on the first read data #ReadA restored to the latch circuit and the third voltage held by the node SEN. Furthermore, the sequencer 25 counts the on-cell count N_CA (second cell count) based on the second difference data #CA held by the latch circuit SDL in each of the plurality of sense amplifier units SAU.

Additionally, the sequencer 25 acquires the on-cell count N_CB (third cell count) by computing a difference between the on-cell count N_CA and the on-cell count N_BA. The sequencer 25 determines which of the three read voltages Rm_def, Rm_def - VCG, and Rm_def + VCG is used as the optimum read voltage Rm_opt (selected sense parameter) based on the on-cell count N_BA and the on-cell count N_CB.

In the read process, the sequencer 25 also reads data from the memory cell transistor MT using the optimum read voltage Rm_opt determined by the tracking process.

With the configuration described above, the optimum read voltage Rm_opt can be determined by using only one latch circuit SDL, so that the adjustment read operation can be more appropriately performed during a suspension of the write operation, for example.

In the tracking process, the sequencer 25 generates the second read data #ReadB in the node SEN by supplying the second voltage corresponding to the second read data #ReadB to the node SEN using the read voltage Rm_def, and converting the voltage at the node SEN into a voltage corresponding to digital data of "0" or "1" thereafter. The sequencer 25 then generates the first difference data #BA in the latch circuit SDL based on the first read data #ReadA held by the latch circuit SDL and the second read data #ReadB generated in the node SEN.

With this configuration, the first difference data #BA can be computed by using only one latch circuit SDL, and the data #BA can be held by the latch circuit SDL.

In the tracking process, the sequencer 25 restores the first read data #ReadA to the latch circuit SDL based on the first difference data #BA held by the latch circuit SDL and the second read data #ReadB held by the node SEN.

With this configuration, the first read data #ReadA can be restored to the latch circuit SDL even when only one latch circuit SDL is used.

The semiconductor storage device 2 further includes the bit scan circuit 29 (counter circuit) configured to count at least one of the on-cell count N_BA and the on-cell count N_CA.

With this configuration, at least one of the on-cell count N_BA and the on-cell count N_CA can be easily counted.

The sense amplifier unit SAU includes the plurality of latch circuits SDL, ADL, BDL, CDL, and TDL. The sequencer 25 uses the latch circuit SDL as one of the plurality of latch circuits SDL, ADL, BDL, CDL, and TDL as a latch circuit for holding the first read data #ReadA, and for computing and holding the first difference data #BA and the second difference data #CA.

With this configuration, the first read data #ReadA can be computed, and the first difference data #BA and the second difference data #CA can be computed and held by using the latch circuit SDL that can be used during a suspension of the write operation.

While the write operation for the plurality of NAND strings NS is temporarily suspended, the sequencer 25 performs the adjustment read operation including the tracking process and the read process using the latch circuit SDL.

With this configuration, the adjustment read operation can be performed by using only one latch circuit SDL.

As shown in FIG. 13, when the differential on-cell count "N_CB - N_BA" (subtraction value) as a value obtained by subtracting the on-cell count N_BA from the on-cell count N_CB is equal to or smaller than zero, and an absolute value of the differential on-cell count "N_CB - N_BA" is larger than a first threshold p1, the sequencer 25 uses the read voltage "Rm_def - VCG" as the optimum read voltage Rm_opt. When the differential on-cell count "N_CB - N_BA" is a positive value, and the differential on-cell count "N_CB - N_BA" is larger than a second threshold p2, the sequencer 25 uses the read voltage "Rm_def + VCG" as the optimum read voltage Rm_opt. Furthermore, when the differential on-cell count "N_CB - N_BA" is equal to or smaller than zero and the absolute value of the differential on-cell count "N_CB - N_BA" is equal to or smaller than the first threshold p1, or when the differential on-cell count "N_CB - N_BA" is a positive value and the differential on-cell count "N_CB - N_BA" is equal to or smaller than the second threshold, the sequencer 25 uses the read voltage Rm_def as the optimum read voltage Rm_opt.

With this configuration, the optimum read voltage Rm_opt can be easily set based on the on-cell count N_BA and the on-cell count N_CB.

The sequencer 25 uses a first read voltage "Rm_def - VCG" as the first sense parameter, uses a second read voltage Rm_def as the second sense parameter, and uses a third read voltage "Rm_def + VCG" as the third sense parameter.

With this configuration, the sense parameter can be easily set.

### 1.9 further embodiment

Next, a further embodiment of the semiconductor storage device 2 according to the first embodiment will be described.

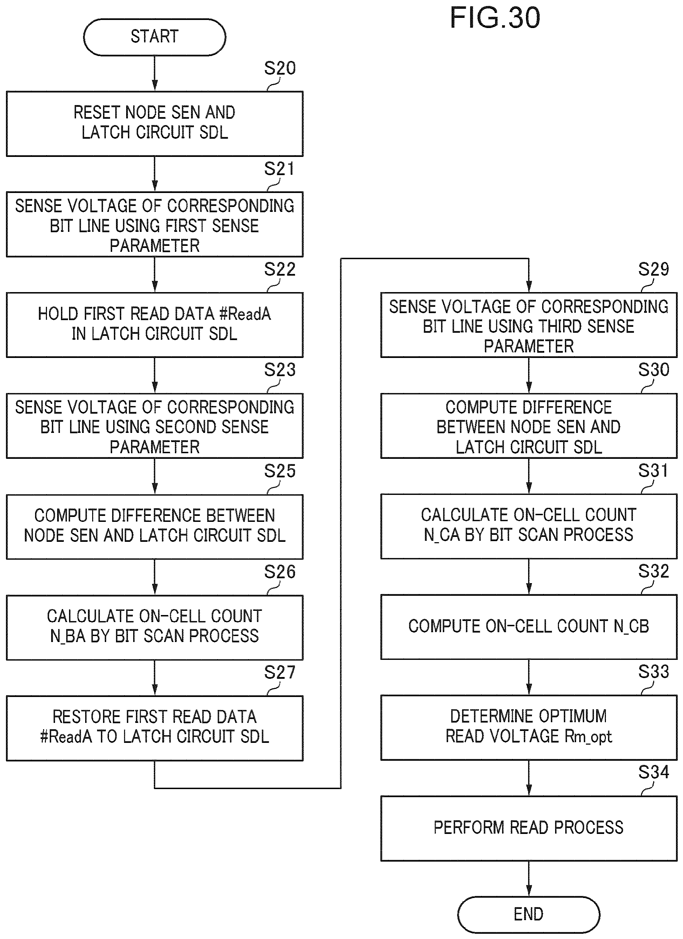

The sequencer 25 in the present further embodiment performs the process shown in FIG. 30 in place of the process shown in FIG. 14A as the adjustment read operation. In the process shown in FIG. 30, the same process as the process shown in FIG. 14A is denoted by the same reference numeral, and redundant description will not be repeated.

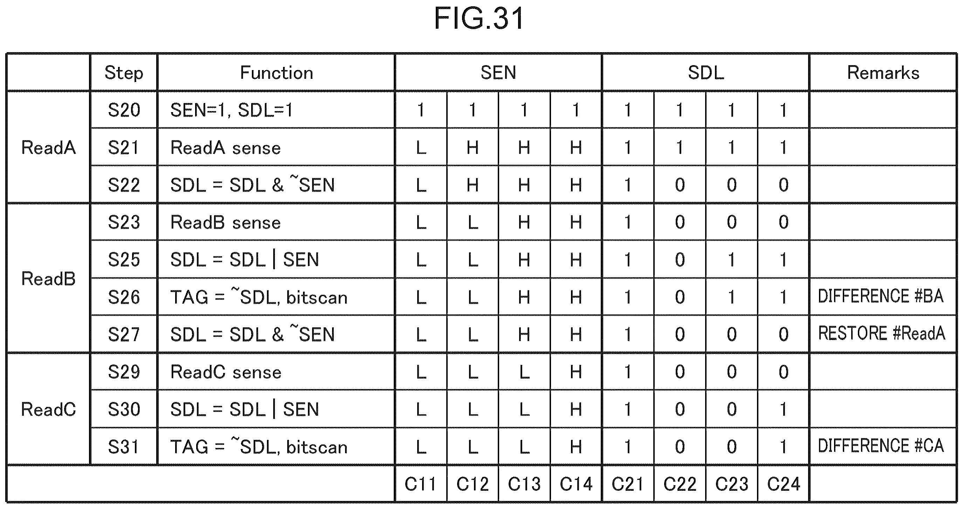

The process shown in FIG. 30 is the same as the process shown in FIG. 14A except that the process at Step S24 and the process at Step S28 shown in FIG. 14A are eliminated. FIG. 31 shows transition of the voltage level at the node SEN and transition of the data held by the node LAT_S of the latch circuit SDL when the process shown in FIG. 30 is performed.

In this manner, in the semiconductor storage device 2, the process at Step S24 for converting the voltage at the node SEN into the voltage corresponding to the digital data, and the process at Step S28 for resetting the node SEN of the sense amplification part SA are not necessarily performed. Even with such a configuration, the first difference data #BA and the second difference data #CA can be computed using only one latch circuit SDL.

### 2 Second embodiment

Next, the semiconductor storage device 2 according to a second embodiment will be described. The following mainly describes differences from the semiconductor storage device 2 in the first embodiment.

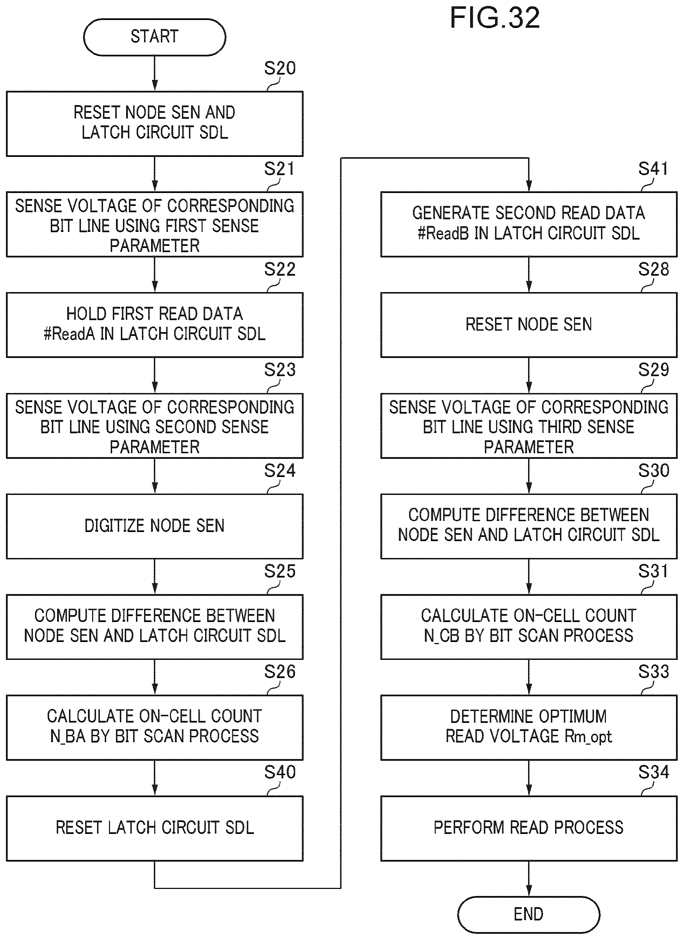

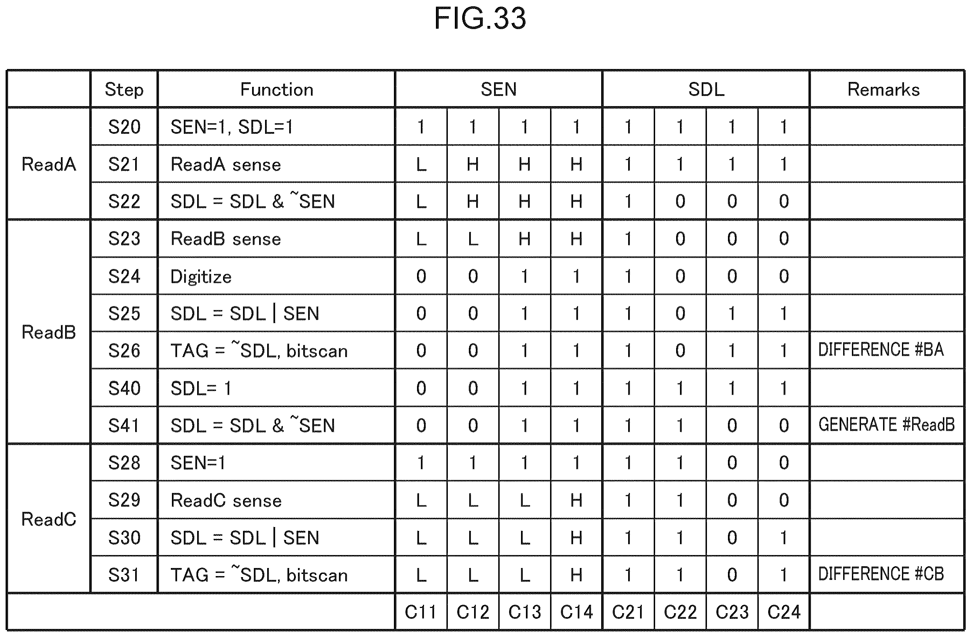

The sequencer 25 in the present embodiment performs a process shown in FIG. 32 in place of the process shown in FIG. 14A as the adjustment read operation. In the process shown in FIG. 32, the same process as the process shown in FIG. 14A is denoted by the same reference numeral, and redundant description will not be repeated. FIG. 33 shows transition of the voltage level at the node SEN and transition of the data held by the node LAT_S of the latch circuit SDL when the process shown in FIG. 32 is performed.

As shown in FIG. 32, the sequencer 25 in the present embodiment resets the latch circuit SDL following the process at Step S26 (Step S40). Specifically, the sequencer 25 sets the signal LPC and the signal STL to the "H" level. Due to this, the transistors 41 and 50 are turned on as shown in FIG. 17, so that the current paths as indicated by the dashed lines L11a and L11b in FIG. 17 are formed, and the power supply voltage VDD is supplied to the node LAT_S of the latch circuit SDL. As a result, as shown at Step S40 in FIG. 33, data of "1" is held by the latch circuit SDL.

As shown in FIG. 32, the sequencer 25 generates the second read data #ReadB in the latch circuit SDL following the process at Step S40 (Step S41). Specifically, the sequencer 25 performs the same process as the process at Step S22, that is, the process of computing "SDL = SDL&^{~}SEN". At the time when the process at Step S40 is performed, the second read data #ReadB is held by the node SEN and the latch circuit SDL is reset, so that the second read data #ReadB is transferred from the node SEN to the latch circuit SDL as shown at Step S41 in FIG. 33 by computation of "SDL = SDL& SEN".

Thereafter, as shown in FIG. 32, the sequencer 25 performs the process at Steps S28 to S30. At the time when the process at Step S29 is completed, the second read data #ReadB is held by the latch circuit SDL. Additionally, the voltage corresponding to the third read data #ReadC is held by the node SEN. Thus, the process at Step S30 corresponds to a process of computing difference data #CB thereof (= #ReadC - #ReadB).

Subsequently, the sequencer 25 computes the on-cell count N_CB in the bit scan process (Step S31). After determining the optimum read voltage Rm_opt using the on-cell count N_BA obtained by the process at Step S26 and the on-cell count N_CB obtained by the process at Step S31 (Step S33), the sequencer 25 performs the read process (Step S34).

In this manner, in the semiconductor storage device 2 according to the present embodiment, the process at Step S41 for generating the second read data #ReadB in the latch circuit SDL is performed in place of the process at Step S27 shown in FIG. 14A, that is, the process of restoring the first read data #ReadA to the latch circuit SDL. Due to this, the on-cell count N_CB can be computed by the process at Step S31, so that the process at Step S32 shown in FIG. 14A, that is, the process of computing the on-cell count N_CB, is not required. Thus, a computation process can be simplified.

### 3 Other embodiments

The present disclosure is not limited to the specific examples described above.

For example, the method of selecting the optimum read voltage Rm_opt from the three read voltages Rm_def, Rm_def - VCG, and Rm_def + VCG is not limited to the method shown in FIG. 14A, but an optional method can be adopted.

FIG. 14B shows the example in which the voltage applied to the selected word line WLsel is changed as the first sense parameter, the second sense parameter, and the third sense parameter, but the first sense parameter, the second sense parameter, and the third sense parameter can be appropriately changed. For example, in a state in which a certain read voltage is applied to the selected word line WLsel, the first sense time may be used as the first sense parameter, the second sense time longer than the first sense time may be used as the second sense parameter, and the third sense time longer than the second sense time may be used as the third sense parameter. As described above, the sense time is a time for setting the signal XXL to the "H" level after charging the node SEN in the sense amplification part SA, or a time for electrically connecting the node SEN with the bit line BL.

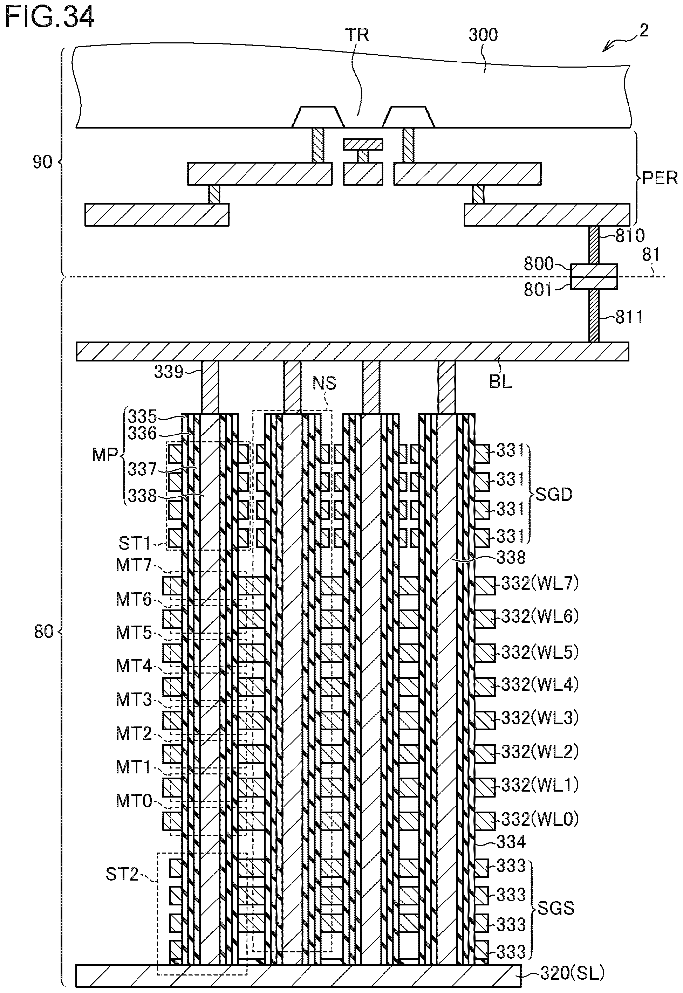

The structure of the semiconductor storage device 2 is not limited to the structure as shown in FIG. 4, but may be appropriately changed. For example, the semiconductor storage device 2 may have a CMOS Bonding Array (CBA) structure as shown in FIG. 34. In the semiconductor storage device 2 shown in FIG. 34, a memory part 80 in which the memory cell array 21 is disposed and a control circuit part 90 in which the peripheral circuit PER is disposed are separately manufactured. The semiconductor storage device 2 is configured by bonding the separately manufactured memory part 80 and control circuit part 90 at a bonding surface 81 to be joined to each other. The memory cell array 21 and the peripheral circuit PER are electrically connected to each other via interconnect layers 800 and 801 disposed at the bonding surface 81, and vias 810 and 811.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

Some or all of the embodiments described above can be described as in the following supplementary notes, but is not limited thereto:

### [Supplementary Note 1]

A semiconductor storage device (2) comprising:
a plurality of memory strings (NS) including a plurality of memory cell transistors (MT);
a plurality of bit lines (BL) respectively connected to the plurality of memory strings;
a plurality of sense amplifier units (SAU) respectively connected to the plurality of bit lines; and
a control circuit (25) configured to perform a read operation including a first process and a second process, wherein
the sense amplifier unit includes:
   a sense node (SEN) connected to the memory cell transistor via the bit line;
   a sense amplification part (SA) configured to convert a voltage at the sense node into data; and
   a latch circuit (SDL, ADL, BDL, CDL, TDL) configured to hold the data converted by the sense amplification part,
the control circuit
   supplies, in the first process, a first voltage to the sense node via the bit line by sensing data held by the memory cell transistor using a first sense parameter,
   converts the first voltage at the sense node into first read data by the sense amplification part to be held by the latch circuit,
   supplies a second voltage to the sense node via the bit line by sensing data held by the memory cell transistor using a second sense parameter,
   generates first difference data in the latch circuit based on the first read data held by the latch circuit and the second voltage held by the sense node,
   counts a first cell count based on the first difference data held by the latch circuit of each of the plurality of sense amplifier units,
   restores the first read data to the latch circuit,
   supplies a third voltage to the sense node via the bit line by sensing data held by the memory cell transistor using a third sense parameter,
   generates second difference data in the latch circuit based on the first read data restored to the latch circuit and the third voltage held by the sense node,
   counts a second cell count based on the second difference data held by the latch circuit of each of the plurality of sense amplifier units,
   acquires a third cell count by computing a difference between the first cell count and the second cell count,
   determines which of the first sense parameter, the second sense parameter, and the third sense parameter is used as a selected sense parameter based on the first cell count and the third cell count, and
the control circuit
   reads, in the second process, data from the memory cell transistor using the selected sense parameter determined in the first process.

### [Supplementary Note 2]

The semiconductor storage device according to Supplementary Note 1, wherein
the control circuit generates, in the first process, second read data at the sense node by supplying the second voltage to the sense node using the second sense parameter, and converting a voltage at the sense node into a voltage corresponding to digital data thereafter, and
generates the first difference data in the latch circuit based on the first read data held by the latch circuit and the second read data generated at the sense node.

### [Supplementary Note 3]

The semiconductor storage device according to Supplementary Note 2, wherein
the control circuit restores, in the first process, the first read data to the latch circuit based on the first difference data held by the latch circuit and the second read data held by the sense node.

### [Supplementary Note 4]

The semiconductor storage device according to any of Supplementary Notes 1 to 3, further comprising:
a counter circuit (29) configured to be able to count at least one of the first cell count and the second cell count.

### [Supplementary Note 5]

The semiconductor storage device according to any of Supplementary Notes 1 to 4, wherein
the sense amplifier unit includes a plurality of latch circuits, and
the control circuit uses any one of the plurality of latch circuits as the latch circuit for holding the first read data, and for computing and holding the first difference data and the second difference data.

### [Supplementary Note 6]

The semiconductor storage device according to Supplementary Note 5, wherein
the control circuit performs the read operation including the first process and the second process using any one of the plurality of latch circuits while a write operation for the plurality of memory strings is temporarily suspended.

### [Supplementary Note 7]

The semiconductor storage device according to any of Supplementary Notes 1 to 6, wherein
the control circuit
determines to use the third sense parameter as the selected sense parameter when a subtraction value as a value obtained by subtracting the first cell count from the third cell count is equal to or smaller than zero, and an absolute value of the subtraction value is larger than a first threshold,
determines to use the first sense parameter as the selected sense parameter when the subtraction value is a positive value and the subtraction value is larger than a second threshold, and
determines to use the second sense parameter as the selected sense parameter when the subtraction value is equal to or smaller than zero and the absolute value of the subtraction value is equal to or smaller than the first threshold, or when the subtraction value is a positive value and the subtraction value is equal to or smaller than the second threshold.

### [Supplementary Note 8]

The semiconductor storage device according to any of Supplementary Notes 1 to 7, wherein
the control circuit
uses a first read voltage as the first sense parameter,
uses a second read voltage higher than the first read voltage as the second sense parameter, and
uses a third read voltage higher than the second read voltage as the third sense parameter.

### [Supplementary Note 9]

The semiconductor storage device according to any of Supplementary Notes 1 to 8, wherein
the control circuit
uses a first sense time as the first sense parameter,
uses a second sense time longer than the first sense time as the second sense parameter, and
uses a third sense time longer than the second sense time as the third sense parameter.

### [Supplementary Note 10]

The semiconductor storage device according to any of Supplementary Notes 1 to 9, wherein
the memory string is a NAND string.

### [Supplementary Note 11]

A semiconductor storage device (2) comprising:
a plurality of memory strings (NS) including a plurality of memory cell transistors (MT);
a plurality of bit lines (BL) respectively connected to the plurality of memory strings;
a plurality of sense amplifier units SAU) respectively connected to the plurality of bit lines; and
a control circuit (25) configured to perform a read operation including a first process and a second process,
   wherein
the sense amplifier unit includes:
   a sense node (SEN) connected to the memory cell transistor via the bit line;
   a sense amplification part (SA) configured to convert a voltage at the sense node into data; and
   a latch circuit (SDL, ADL, BLD, CDL, TDL) configured to hold the data converted by the sense amplification part,
the control circuit
   supplies, in the first process, a first voltage to the sense node via the bit line by sensing data held by the memory cell transistor using a first sense parameter,
   converts the first voltage at the sense node into first read data by the sense amplification part to be held by the latch circuit,
   supplies a second voltage to the sense node via the bit line by sensing data held by the memory cell transistor using a second sense parameter,
   generates first difference data in the latch circuit based on the first read data held by the latch circuit and the second voltage held by the sense node,
   counts a first cell count based on the first difference data held by the latch circuit of each of the plurality of sense amplifier units,
   transfers second read data corresponding to the second voltage from the sense node to the latch circuit,
   supplies a third voltage to the sense node via the bit line by sensing data held by the memory cell transistor using a third sense parameter,
   generates second difference data in the latch circuit based on the second read data held by the latch circuit and the third voltage held by the sense node,
   counts a second cell count based on the second difference data held by the latch circuit of each of the plurality of sense amplifier units,
   determines which of the first sense parameter, the second sense parameter, and the third sense parameter is used as a selected sense parameter based on the first cell count and the second cell count, and
the control circuit
   reads, in the second process, data from the memory cell transistor using the selected sense parameter determined in the first process.

## Claims

1. A semiconductor storage device (2) comprising:
a plurality of memory strings (NS) including a plurality of memory cell transistors (MT);
a plurality of bit lines (BL) respectively connected to the plurality of memory strings;
a plurality of sense amplifier units (SAU) respectively connected to the plurality of bit lines; and
a control circuit (25) configured to perform a read operation including a first process and a second process, wherein
the sense amplifier unit (SAU) includes:
a sense node (SEN) connected to the memory cell transistor via the bit line;
a sense amplification part (SA) configured to convert a voltage at the sense node into data; and
a latch circuit (SDL) configured to hold the data converted by the sense amplification part,
the control circuit (25)
supplies (S21), in the first process, a first voltage ("L" or "H") to the sense node (SEN) via the bit line (BL) by sensing data held by the memory cell transistor using a first sense parameter (RM_def-VCG),
converts (S22) the first voltage ("L" or "H") at the sense node (SEN) into first read data by the sense amplification part (SA) to be held by the latch circuit (SDL),
supplies (S23) a second voltage ("L" or "H") to the sense node (SEN) via the bit line (BL) by sensing data held by the memory cell transistor using a second sense parameter (RM_def),
generates (S25) first difference data (SDL = SDL | SEN) in the latch circuit (SDL) based on the first read data held by the latch circuit (SDL) and the second voltage held by the sense node (SEN),
counts (S26) a first cell count (N_BA) based on the first difference data (SDL = SDL | SEN) held by the latch circuit (SDL) of each of the plurality of sense amplifier units (SAU),
restores (S27) the first read data to the latch circuit (SDL),
supplies (S29) a third voltage ("L" or "H") to the sense node (SEN) via the bit line (BL) by sensing data held by the memory cell transistor using a third sense parameter (RM_def+VCG),
generates (S30) second difference data (SDL = SDL | SEN) in the latch circuit (SDL) based on the first read data restored to the latch circuit (SDL) and the third voltage held by the sense node (SEN),
counts (S31) a second cell count (N_CA) based on the second difference data (SDL = SDL | SEN) held by the latch circuit (SDL) of each of the plurality of sense amplifier units (SAU),
acquires (S32) a third cell count (N_CB) by computing a difference between the first cell count (N_BA) and the second cell count (N_CA),
determines (S33) which of the first sense parameter (RM_def-VCG), the second sense parameter (RM_def), and the third sense parameter (RM_def+VCG) is used as a selected sense parameter based on the first cell count (N_BA) and the third cell count (N_CB), and
the control circuit (25)
reads, in the second process, data from the memory cell transistor using the selected sense parameter determined in the first process.

2. The semiconductor storage device according to claim 1, wherein
the control circuit generates, in the first process, second read data at the sense node by supplying the second voltage to the sense node using the second sense parameter, and converting a voltage at the sense node into a voltage corresponding to digital data thereafter, and
generates the first difference data in the latch circuit based on the first read data held by the latch circuit and the second read data generated at the sense node.

3. The semiconductor storage device according to claim 2, wherein
the control circuit restores, in the first process, the first read data to the latch circuit based on the first difference data held by the latch circuit and the second read data held by the sense node.

4. The semiconductor storage device according to any of claims 1 to 3, further comprising:
a counter circuit (29) configured to be able to count at least one of the first cell count and the second cell count.

5. The semiconductor storage device according to any of claims 1 to 4, wherein
the sense amplifier unit includes a plurality of latch circuits, and
the control circuit uses any one of the plurality of latch circuits as the latch circuit for holding the first read data, and for computing and holding the first difference data and the second difference data.

6. The semiconductor storage device according to claim 5, wherein
the control circuit performs the read operation including the first process and the second process using any one of the plurality of latch circuits while a write operation for the plurality of memory strings is temporarily suspended.

7. The semiconductor storage device according to any of claims 1 to 6, wherein
the control circuit
determines to use the third sense parameter as the selected sense parameter when a subtraction value as a value obtained by subtracting the first cell count from the third cell count is equal to or smaller than zero, and an absolute value of the subtraction value is larger than a first threshold,
determines to use the first sense parameter as the selected sense parameter when the subtraction value is a positive value and the subtraction value is larger than a second threshold, and
determines to use the second sense parameter as the selected sense parameter when the subtraction value is equal to or smaller than zero and the absolute value of the subtraction value is equal to or smaller than the first threshold, or when the subtraction value is a positive value and the subtraction value is equal to or smaller than the second threshold.

8. The semiconductor storage device according to any of claims 1 to 7, wherein
the control circuit
uses a first read voltage as the first sense parameter,
uses a second read voltage higher than the first read voltage as the second sense parameter, and
uses a third read voltage higher than the second read voltage as the third sense parameter.

9. The semiconductor storage device according to any of claims 1 to 8, wherein
the control circuit
uses a first sense time as the first sense parameter,
uses a second sense time longer than the first sense time as the second sense parameter, and
uses a third sense time longer than the second sense time as the third sense parameter.

10. The semiconductor storage device according to any of claims 1 to 9, wherein
the memory string is a NAND string.

11. A semiconductor storage device (2) comprising:
a plurality of memory strings (NS) including a plurality of memory cell transistors (MT);
a plurality of bit lines (BL) respectively connected to the plurality of memory strings;
a plurality of sense amplifier units (SAU) respectively connected to the plurality of bit lines; and
a control circuit (25) configured to perform a read operation including a first process and a second process, wherein
the sense amplifier unit includes:
a sense node (SEN) connected to the memory cell transistor via the bit line;
a sense amplification part (SA) configured to convert a voltage at the sense node into data; and
a latch circuit (SDL) configured to hold the data converted by the sense amplification part,
the control circuit (25)
supplies (S21), in the first process, a first voltage ("L" or "H") to the sense node (SEN) via the bit line (BL) by sensing data held by the memory cell transistor using a first sense parameter (RM_def-VCG),
converts (S22) the first voltage ("L" or "H") at the sense node (SEN) into first read data by the sense amplification part (SA) to be held by the latch circuit (SDL),
supplies (S23) a second voltage ("L" or "H") to the sense node (SEN) via the bit line (BL) by sensing data held by the memory cell transistor using a second sense parameter (RM_def),
generates (S25) first difference data (SDL = SDL | SEN) in the latch circuit (SDL) based on the first read data held by the latch circuit (SDL) and the second voltage held by the sense node (SEN),
counts (S26) a first cell count (N_BA) based on the first difference data (SDL = SDL | SEN) held by the latch circuit (SDL) of each of the plurality of sense amplifier units (SAU),
transfers (S41) second read data corresponding to the second voltage from the sense node (SEN) to the latch circuit (SDL),
supplies (S29) a third voltage ("L" or "H") to the sense node (SEN) via the bit line (BL) by sensing data held by the memory cell transistor using a third sense parameter (RM_def+VCG),
generates (S30) second difference data (SDL = SDL | SEN) in the latch circuit (SEL) based on the second read data held by the latch circuit (SDL) and the third voltage held by the sense node (SEN),
counts (S31) a second cell count (N_CB) based on the second difference data (SDL = SDL | SEN) held by the latch circuit (SDL) of each of the plurality of sense amplifier units (SAU),
determines (S32) which of the first sense parameter (RM_def-VCG), the second sense parameter (RM_def), and the third sense parameter (RM_def+VCG) is used as a selected sense parameter based on the first cell count (N_BA) and the second cell count (N_CB), and
the control circuit (25)
reads, in the second process, data from the memory cell transistor using the selected sense parameter determined in the first process.
